(19) **Europäisches Patentamt**
**European Patent Office**
**Office européen des brevets**

(11) **EP 3 533 579 A1**

(12) **EUROPEAN PATENT APPLICATION**
published in accordance with Art. 153(4) EPC

(43) Date of publication:
**04.09.2019 Bulletin 2019/36**

(21) Application number: **17832980.1**

(22) Date of filing: **31.10.2017**

(51) Int Cl.:
*B29C 39/00* (2006.01)    *B29C 39/02* (2006.01)
*B29C 39/10* (2006.01)    *H01L 23/367* (2006.01)
*H01L 23/373* (2006.01)    *H01L 23/433* (2006.01)
*B29K 83/00* (2006.01)

(86) International application number:
**PCT/IB2017/001308**

(87) International publication number:
**WO 2018/078436 (03.05.2018 Gazette 2018/18)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **31.10.2016 JP 2016213184
03.08.2017 JP 2017151151**

(71) Applicant: **3M Innovative Properties Company
St. Paul, MN 55133-3427 (US)**

(72) Inventors:
• **UCHIYA, Tomoaki**
**Sagamihara-shi**
**Kanagawa 252-5285 (JP)**

• **SAKAGUCHI, Ryo**
**Sagamihara-shi**
**Kanagawa 252-5285 (JP)**
• **TAKASHINA, Tadahiro**
**Sagamihara-shi**
**Kanagawa 252-5285 (JP)**
• **NEZU, Masaru**
**Sagamihara-shi**
**Kanagawa 252-5285 (JP)**
• **TAKENOUCHI, Takashi**
**Sagamihara-shi**
**Kanagawa 252-5285 (JP)**

(74) Representative: **Isarpatent
Patent- und Rechtsanwälte Behnisch Barth
Charles
Hassa Peckmann & Partner mbB
Friedrichstrasse 31
80801 München (DE)**

(54) **THREE-DIMENSIONALLY SHAPED THERMALLY CONDUCTIVE MOLDED BODY, AND MANUFACTURING METHOD THEREOF**

(57)    Provided is a three-dimensionally shaped thermally conductive molded body and manufacturing method thereof, that can ensure sufficient gap filling properties and contact surface area with regard to heat dissipating components such as heat sinks and the like and heat generating components such as IC chips and the like, without adding excessive stress to these components. The three-dimensionally shaped thermally conductive molded body of a first aspect of the present disclosure contains a thermally conductive material and a silicone-based material, the molded body has a substantially flat bottom surface, and a three-dimensional shaped part located on the inside of the bottom surface, and the height of the three-dimensionally shaped part that is higher than the bottom surface differs in at least two locations.

**EP 3 533 579 A1**

[FIG. 1]

**Description**

FIELD OF THE INVENTION

The present disclosure relates to a three-dimensionally shaped thermally conductive molded body and to a method of manufacturing thereof.

BACKGROUND ART

In order to efficiently cool heat generation of heat generating components (power transistors, thyristors, and the like) and integrated circuits (IC, LSI, and the like) that constitute electronic devices, heat dissipation of heat generating components is enhanced by applying a thick heat dissipation sheet in the gap between these components and a heat sink such as a heat dissipating plate, housing, and the like. There is a possibility that a conventional heat dissipating sheet can be damaged by applying excessive stress to the substrate and adjacent elements when thermal expansion occurs, for example, because the flexibility is inferior. Therefore, a more flexible heat dissipating sheet is needed.

Patent Literature 1 (JP 3492656 B) discloses a method of manufacturing a thermally conductive sheet by injecting a predetermined amount of a fluid thermally conductive grease from an opening part in a bag shaped thin-film sheet, spreading the thermally conductive grease along the outline of the bag, hermetically sealing the opening part while evacuating the internal air, shrinking the thin-film sheets by hot air and shaping to a final thin-film shape.

Patent Literature 2 (JP 2728607 B) discloses a method of manufacturing a thermally conductive composite sheet, including combining a heat dissipating insulative sheet made by coating and curing a web shaped reinforcing material with a silicone rubber containing a thermally conductive filler, and a heat dissipating insulative sheet made by integrally molding by mold forming, injection molding, or coating molding uncured addition type liquid silicone rubber containing a thermally conductive filler where the hardness after curing is within a range of 10 to 95 as determined by an Asker F hardness tester.

Patent Literature 3 (JP 2938340 B) discloses a thermally conductive composite sheet containing a silicone rubber layer containing a thermally conductive filler material and having an Asker C hardness of 5 to 50, and a porous reinforcing material layer having voids with a diameter of 0.3 mm or greater included and interwoven in the silicone rubber layer.

Patent Literature 4 (JP 3382842 B) discloses a cooling structure for electronic components where a plurality of electronic components with different component heights are mounted on a printed wiring board, a heat sink is connected by a heat transfer member made of a material with flexibility and high heat conductivity, on a surface on an opposite side as the printed wiring board of these electronic components, a plurality of cylindrical protrusions that gradually become thicker when moving from a flat tip end surface toward the other end of the substrate side are integrally formed to be mutually proximal on a surface facing the electronic components on the heat transfer member, the tip end surface of the cylindrical protrusions is pressed into the electronic components and a heat transfer member is provided between the electronic component and the heat sink in a condition where a groove with a V-shaped cross-section is formed between mutually adjacent cylindrical protrusions.

PRIOR ART DOCUMENTS

Patent Literature

Patent Literature 1: JP 3492656 B
Patent Literature 2: JP 2728607 B
Patent Literature 3: JP 2938340 B
Patent Literature 4: JP 3382842 B

SUMMARY OF THE INVENTION

Problem to be Solved by the Invention

It is known that the performance for filling a gap (hereinafter also referred to as "gap filling properties") between heat generating components and heat dissipating components such as a heat sink or the like in a heat conductive sheet is enhanced as the flexibility of the sheet increases. However, there is a problem that in a case where the sheet is too flexible, maintaining the shape of the sheet becomes difficult, and in some cases, the constituent material of the sheet protruding from the end part of the sheet contaminates adjacent electronic parts or the like. A standard thermally conductive sheet has a sheet-like shape with both main surfaces being flat (Patent Literature 2 to 3), and in the case of a conventional flexible thermally conductive sheet, an outer skin made of a plastic material such as polysulfone or the like having inferior flexibility is provided (Patent Literature 1), so there is a problem that air trapping tends to readily occur between heat generating components and heat sinks and the like, and sufficient contact area cannot be ensured.

The present disclosure provides a three-dimensionally shaped thermally conductive molded body and method of manufacturing thereof, that can ensure sufficient gap filling properties and contacts surface area with regard to heat dissipating components such as heat sinks and the like and heat generating components such as IC chips and the like, without adding excessive stress to these components.

MEANS FOR SOLVING THE PROBLEM

The first aspect of the present disclosure provides a three-dimensionally shaped thermally conductive molded body containing a thermally conductive material and a silicone-based material, wherein the molded body has a substantially flat bottom surface and a three-dimensionally shaped part located on the inside of the bottom surface, and the height of the three-dimensionally shaped part that is higher than the bottom surface differs in at least two locations.

Another aspect of the present disclosure provides a method of manufacturing a three-dimensionally shaped thermally conductive molded body, including: preparing a mixture containing a thermally conductive material and a silicone-based material; preparing a mold that can provide a molded body with a substantially flat bottom surface, and a three-dimensionally shaped part located on the inside of the bottom surface, and the height of the three-dimensionally shaped part that is higher than the bottom surface differs in at least two locations; providing an extensible film on the mold so as to enable contact with the mold inner surface; overlaying the extensible film on the mold; filling the mixture into a hollow part of the mold on which the extensible film has been placed, and performing an optional smoothing process of a portion that forms the bottom surface of the molded body; curing the mixture in the mold; and providing the three-dimensionally thermally conductive molded body by optionally cooling the mold, removing the three-dimensionally shaped thermally conductive molded body with an extensible film from the mold, optionally removing the extensible film, and optionally punching out a portion that does not have the mold shape.

Another aspect of the present disclosure provides a method of manufacturing a three-dimensionally shaped thermally conductive molded body, including: forming the upper part outer layer by applying and curing a first silicone-based material containing a thermally conductive material, on the extensible film of a laminate film containing an extensible film and a release film; removing the release film of a laminate film having the upper part outer layer, and then placing the laminate film on the mold such that the extensible film can contact the inner surface of the mold, where the mold is a mold that can provide a molded body with a substantially flat bottom surface, and a three-dimensionally shaped part located on the inside of the bottom surface, and the height of the three-dimensionally shaped part that is higher than the bottom surface differs in at least two locations; overlaying the laminate film on the mold; filling the middle member containing a second silicone-based material including a thermally conductive material into a hollow part of the mold on which the laminate film was overlaid, and optionally performing a smoothing process of a portion positioned on the bottom surface side of the molded body; optionally forming the bottom part outer layer by applying a third silicone-based material containing a thermally conductive material onto the release film and placing the release film containing the bottom part outer layer on the mold such that the release film is an outermost layer, such that the bottom part outer layer covers the upper part outer layer and the middle member filled in the hollow part; curing the second silicone-based material that forms the middle member and the third silicone-based material that forms the bottom part outer layer if present; providing the three-dimensionally thermally conductive molded body by optionally cooling the mold, removing the three-dimensionally shaped thermally conductive molded body with an extensible film and an optional release film if present from the mold, optionally removing the extensible film and/or the optional release film if present, and optionally punching out the upper part outer layer portion that does not include the middle member and the bottom part outer layer portion if present.

Yet another aspect of the present disclosure provides a three-dimensionally shaped thermally conductive molded body having a plurality of protruding layers and a bottom part outer layer, wherein

the protruding layer includes a thermally conductive material and a silicone-based material;

the bottom part outer layer includes a thermally conductive material, a silicone-based material, and a reinforcing base;

the protruding layers arranged to provide a gap between adjacent protruding layers such that the bottom surface outer circumferential parts of adjacent protruding layers do not contact; and

the following Equation (I) is satisfied

[Equation 1]

$$\alpha Y = 100 - X \text{ (I)}$$

[in the equation, $\alpha$ is approximately 0.70 to approximately 1.00, X is the compression ratio (%) when the gap is completely filled by compression deforming of the protruding layer, and Y is the ratio (%) of the total surface area of the bottom part outer layer upper surface occupied by the total surface area of the protruding layer bottom surface].

Yet another aspect of the present disclosure provides a method of manufacturing a three-dimensionally shaped thermally conductive molded body including:

preparing a mixture containing a thermally conductive material and a silicone-based material;
preparing a mold that can form the protruding layers and gaps of the three-dimensionally shaped thermally conductive molded bodies;
providing an extensible film on the mold so as to enable contact with the mold inner surface;
overlaying the extensible film on the mold;
filling the mixture into a hollow part of the mold on which the extensible film has been overlaid;
placing the laminate film for the bottom part outer layer having a bottom part outer layer on the release film onto the mold such that the bottom part outer layer covers the mixture filled in the gap part and the release film forms the outermost layer;
curing the mixture and the silicone-based material of the bottom part outer layer; and
providing the three-dimensionally thermally conductive molded body by removing the three-dimensionally shaped thermally conductive molded body with an extensible film from the mold, after optionally cooling the mold, and optionally removing the extensible film.

EFFECT OF THE INVENTION

The present disclosure provides a three-dimensionally shaped thermally conductive molded body and method of manufacturing thereof, that can ensure sufficient gap filling properties and contacts surface area with regard to heat dissipating components such as heat sinks and the like and heat generating components such as IC chips and the like, without adding excessive stress to these components.

The present disclosure provides a three-dimensionally shaped thermally conductive molded body with excellent properties for preventing protruding from an end part or the like of the constituent material, as well as a method of manufacturing thereof.

The present disclosure provides a three-dimensionally shaped thermally conductive molded body that can increase the contact surface area to an adherend, and that has excellent heat dissipating properties, tear resistance, stress relaxation (flexibility), assemblability, and the like, as well as a method of manufacturing thereof.

The present disclosure provides a three-dimensionally shaped thermally conductive molded body with excellent heat resistance, as well as a method of manufacturing thereof.

The present invention provides a three-dimensionally shaped thermally conductive molded body with excellent gap filling properties, even if the various heights of the plurality of heat generating parts are different, for example, as well as a method of manufacturing thereof.

The present invention provides a three-dimensionally shaped thermally conductive molded body that can be molded using extremely flexible material, as well as a method of manufacturing thereof.

The above description should not be construed as disclosing all aspects of the present invention nor all advantages relating to the present invention.

BRIEF DESCRIPTION OF THE DRAWINGS

FIG. 1 is a cross section view of a three-dimensionally shaped thermally conductive molded body according to one aspect of the present disclosure.
FIGS. 2A to 2H are diagrams schematically describing a process for molding the three-dimensionally shaped thermally conductive molded body using a vacuum heat and compression bonding device.
FIG. 3 is a perspective view of a three-dimensionally shaped thermally conductive molded body according to one aspect of the present disclosure.
FIG. 4 is a perspective view of a three-dimensionally shaped thermally conductive molded body according to another aspect of the present disclosure.

FIG. 5 is a perspective view of a three-dimensionally shaped thermally conductive molded body according to another aspect of the present disclosure.

FIG. 6 is a perspective view of a three-dimensionally shaped thermally conductive molded body according to another aspect of the present disclosure.

FIG. 7 is a perspective view of a three-dimensionally shaped thermally conductive molded body according to another aspect of the present disclosure.

FIG. 8 is a perspective view of a three-dimensionally shaped thermally conductive molded body according to another aspect of the present disclosure.

FIG. 9 is a perspective view of a three-dimensionally shaped thermally conductive molded body according to another aspect of the present disclosure.

FIG. 10 is a cross section view of a three-dimensionally shaped thermally conductive molded body according to yet another aspect of the present disclosure.

FIG. 11 is a perspective view of a three-dimensionally shaped thermally conductive molded body according to yet another aspect of the present disclosure.

FIG. 12 is a schematic diagram of the measurement principles for thermal resistance.

FIG. 13 is a perspective view of a three-dimensionally shaped thermally conductive molded body according to yet another aspect of the present disclosure.

FIG. 14 is a perspective view of a three-dimensionally shaped thermally conductive molded body according to yet another aspect of the present disclosure.

## BEST MODE FOR CARRYING OUT THE INVENTION

The three-dimensionally shaped thermally conductive molded body of the first embodiment is a three-dimensionally shaped thermally conductive molded body containing a thermally conductive material and a silicone-based material, the molded body having a substantially flat bottom surface and a three-dimensionally shaped part located on the inside of the bottom surface, and the height of the three-dimensionally shaped part that is higher than the bottom surface differs in at least two locations. This three-dimensionally shaped thermally conductive molded body has a predetermined three-dimensionally shaped part, and therefore can ensure sufficient contact surface area without adding excessive stress to the applied adherend.

With the three-dimensionally shaped thermally conductive molded body according to the first embodiment, at least a portion of the three-dimensionally shaped part may be covered by an upper part outer layer containing a silicone-based material. The properties for preventing protrusion at the end part of the molded body can be enhanced by providing this upper part outer layer.

With the three-dimensionally shaped thermally conductive molded body according to the first embodiment, a nonwoven material may be present on the bottom surface side. If a nonwoven material is present on the bottom surface side of the molded body, stretching of the molded body in a planar direction can be suppressed, and the handling properties can be enhanced without causing defects such as cracking or the like when removing the molded body from the mold.

With the three-dimensionally shaped thermally conductive molded body according to the first embodiment, at least a portion of the three-dimensionally shaped part may have a substantially dome shape or a substantially domed prism shape. This three-dimensionally shaped part can better ensure sufficient contact surface area to the applied adherend.

With the three-dimensionally shaped thermally conductive molded body according to the first embodiment, the shape of the three-dimensionally shaped part substantially matches the shape of an adherend to which the shaped part is applied. The stress on the adherend member can be minimized and sufficient contact surface area to the adherend can be ensured by causing the three-dimensionally shaped part to substantially match the shape of the adherend member that is applied.

The three-dimensionally shaped thermally conductive molded body according to the first embodiment may include a bottom part outer layer with a bottom surface, an upper part outer layer provided so as to cover the bottom part outer layer, and a middle member provided between the bottom part outer layer and the upper part outer layer, and the upper part outer layer, middle member, and bottom part outer layer can contain a silicone-based material. A molded body having this configuration can be freely designed depending on the application, using the contact surface area to the adherend and the flexibility of the molded body.

With the three-dimensionally shaped thermally conductive molded body of the first embodiment, the upper part outer layer and the bottom part outer layer, or the bottom part outer layer and the middle member can be integrated and made of the same material. With this configuration, a molded body with excellent adhesion can be obtained.

With the three-dimensionally shaped thermally conductive molded body of the first embodiment, the upper part outer layer may contain silicone rubber, the middle member may contain silicone gel, and the bottom part outer layer may contain silicone rubber or silicone gel. With a configuration where the middle member that is flexible and can easily deform, for example, if covered by the upper part outer layer containing silicon rubber, the flexibility of the molded body can be enhanced while increasing the properties for preventing protrusion from the end part or the like. The upper part outer layer has rubber elasticity, so if pressure is applied from the outside to the molded body, for example, the middle member made of silicone gel can easily deform, but once the pressure is removed, the deformed middle member can return to the original shape by the recovery force in conjunction with the rubber elasticity of the upper part outer layer, and therefore the reworkability is also excellent.

With the three-dimensionally shaped thermally conductive molded body of the first embodiment, the middle member can be more flexible than the upper part outer layer and/or the bottom part outer layer. With this configuration, the gap filling properties of the molded body can be enhanced.

With the three-dimensionally shaped thermally conductive molded body according to the first embodiment, the tackiness of the bottom surface and the surface portion of the three-dimensionally shaped thermally conductive molded body can be different, excluding the bottom surface. This molded body having tackiness will adhere to either adherend without breaking during rework, and therefore the rework operation can easily be performed.

The method of manufacturing the three-dimensionally shaped thermally conductive molded body of the first embodiment includes: preparing a mixture containing a thermally conductive material and a silicone-based material; preparing a mold that can provide a molded body with a substantially flat bottom surface, and a three-dimensionally shaped part located on the inside of the bottom surface, and the height of the three-dimensionally shaped part that is higher than the bottom surface differs in at least two locations; providing an extensible film on the mold so as to enable contact with the mold inner surface; overlaying the extensible film on the mold; filling the mixture into a hollow part of the mold on which the extensible film has been placed, and performing an optional smoothing process of a portion that forms the bottom surface of the molded body; curing the mixture in the mold; and providing the three-dimensionally thermally conductive molded body by optionally cooling the mold, removing the three-dimensionally shaped thermally conductive molded body with an extensible film from the mold, optionally removing the extensible film, and optionally punching out a portion that does not have the mold shape.

Another method of manufacturing the three-dimensionally shaped thermally conductive molded body of the first embodiment includes: forming the upper part outer layer by applying and curing a first silicone-based material containing a thermally conductive material, on the extensible film of a laminate film containing an extensible film and a release film; removing the release film of a laminate film having the upper part outer layer, and then placing the laminate film on the mold such that the extensible film can contact the inner surface of the mold, where the mold is a mold that can provide a molded body with a substantially flat bottom surface, and a three-dimensionally shaped part located on the inside of the bottom surface, and the height of the three-dimensionally shaped part that is higher than the bottom surface differs in at least two locations; overlaying the laminate film on the mold; filling the middle member containing a second silicone-based material including a thermally conductive material into a hollow part of the mold on which the laminate film was overlaid, and optionally performing a smoothing process of a portion positioned on the bottom surface side of the molded body; optionally forming the bottom part outer layer by applying a third silicone-based material containing a thermally conductive material onto the release film and placing the release film containing the bottom part outer layer on the mold such that the release film is an outermost layer, such that the bottom part outer layer covers the upper part outer layer and the middle member filled in the hollow part; curing the second silicone-based material that forms the middle member and the third silicone-based material that forms the bottom part outer layer if present; providing the three-dimensionally thermally conductive molded body by optionally cooling the mold, removing the three-dimensionally shaped thermally conductive molded body with an extensible film and an optional release film if present from the mold, optionally removing the extensible film and/or the optional release film if present, and optionally punching out the upper part outer layer portion that does not include the middle member and the bottom part outer layer portion if present.

These methods of manufacturing can produce a three-dimensionally shaped thermally conductive molded body with excellent precision even if a flexible material is used because molding is performed using a mold with a predetermined shape.

The three-dimensionally shaped thermally conductive molded body of the second embodiment has a plurality of protruding layers and a bottom part outer layer, wherein

the protruding layer includes a thermally conductive material and a silicone-based material;

the bottom part outer layer includes a thermally conductive material, a silicone-based material, and a reinforcing base;

the protruding layers arranged to provide a gap between adjacent protruding layers such that the bottom surface outer circumferential parts of adjacent protruding layers do not contact; and

the following Equation (I) is satisfied

Equation (I)

[Equation 2]

$$\alpha Y = 100 - X \text{ (I)}$$

[in the equation, $\alpha$ is approximately 0.70 to approximately 1.00, X is the compression ratio (%) when the gap is completely filled by compression deforming of the protruding layer, and Y is the ratio (%) of the total area of the bottom part outer layer upper surface occupied by the total surface area of the protruding layer bottom surface]. This three-dimensionally shaped thermally conductive molded body has a predetermined protruding layer and gap, and therefore the compressive stress on the adherend can be reduced as compared to a conventional flat heat dissipating sheet, and therefore the heat dissipating properties, tear resistance, stress relaxation (flexibility), and assembleability and the like can be enhanced.

With the three-dimensionally shaped thermally conductive molded body according to the second embodiment, the width of the gap can be substantially uniform. With this configuration, the inside of the gap can be uniformly filled by the protruding layer portion that is compressed and expands in the horizontal direction, and therefore a contact surface with fewer voids after compression can be formed on the adherend.

With the three-dimensionally shaped thermally conductive molded body according to the second embodiment, an upper surface of the protruding layer can be a substantially flat surface. If the upper surface of the protruding layer is a substantially flat surface, a contact surface with fewer voids after compressive deformation of the molded body can easily be formed on the adherend.

With the three-dimensionally shaped thermally conductive molded body of the second embodiment, the shape of the substantially flat surface can be a substantially equilateral triangle, a substantially square shape, a substantially regular pentagon, a substantially regular hexagon, a substantially rectangular shape, or a substantially wavy shape, and the protruding layer can have a cross-sectional part along each leg of the shape, and each adjacent leg of the aforementioned shape of adjacent protruding layers can have a substantially flat shape. A protruding layer with this configuration can easily fill adjacent gaps by the protruding layer portion being compressed and then expanding in the horizontal direction, and a uniform contact surface with few voids can more easily be formed on the adherend application surface after compression.

With the three-dimensionally shaped thermally conductive molded body according to the second embodiment, the taper angle of the protruding layer can be approximately 80° to approximately 90°. The protruding layer will have excellent mold release properties, and a uniform contact surface with fewer voids can more easily be formed on the adherend application surface after compression.

With the three-dimensionally shaped thermally conductive molded body according to the second embodiment, the Asker C hardness of the protruding layer can be approximately 0 to approximately 30. A protruding layer with this hardness will have excellent flexibility, and will have enhanced void filling properties, increased contact surface area to the adherend, and excellent recess and protrusion following properties.

With the three-dimensionally shaped thermally conductive molded body of the second embodiment, the contact surface area when applied to an adherand and compressed 50 % is increased by approximately 40 % or more as compared to the contact surface area when this molded body is applied to the adherand without compressing. A molded body demonstrating this performance will have excellent stress relaxation toward the adherend, and a uniform contact surface with fewer voids can more easily be formed on the adherend application surface after compression.

With the three-dimensionally shaped thermally conductive molded body according to the second embodiment, five or more protruding layers per square inch can be present. A molded body with this configuration can express sufficient heat dissipating properties towards the adherend.

With the three-dimensionally shaped thermally conductive molded body according to the second embodiment, the thickness of the bottom part outer layer can be approximately 0.5 mm or less, and the thickness of the three-dimensionally shaped thermally conductive molded body can be approximately 40 mm or less. A standard heat dissipating sheet tends to have increased compressive stress when thinner, but the molded body of the present disclosure has a predetermined protruding layer and gap, so even at this thickness, the stress relaxation toward the adherend will be excellent, and a uniform contact surface with fewer voids can easily be formed on the application surface of the adherend after compression, and therefore sufficient heat dissipating properties can be expressed toward the adherend.

The method of manufacturing a three-dimensionally shaped thermally conductive molded body of the second embodiment includes: preparing a mixture containing a thermally conductive material and a silicone-based material; preparing a mold that can form the protruding layers and gaps of the three-dimensionally shaped thermally conductive molded bodies; providing an extensible film on the mold so as to enable contact with the mold inner surface; overlaying the extensible film on the mold; filling the aforementioned mixture into a hollow part of the mold on which the extensible film has been overlaid; placing the laminate film for the bottom part outer layer having a bottom part outer layer on the release film onto the mold such that the bottom part outer layer covers the mixture filled in the gap part and the release film forms the outermost layer; curing the mixture and the silicone-based material of the bottom part outer layer; and

providing the three-dimensionally thermally conductive molded body by removing the three-dimensionally shaped thermally conductive molded body with an extensible film from the mold, after optionally cooling the mold, and optionally removing the extensible film. This method of manufacturing can produce a three-dimensionally shaped thermally conductive molded body with excellent precision even if a flexible material is used because molding is performed using a mold with a predetermined shape.

With the method of manufacturing a three-dimensionally shaped thermally conductive molded body of the first or second embodiments, the extensible film can include at least one resin selected from polyolefin resins (polyethylene resins (for example, low density polyethylene resins, medium density polyethylene resins), polypropylene and polyethylene copolymers, and the like), polymethylpentene resins (TPX (registered trademark) resin), ionomer resins, and fluorine resins, and a laminate body of these resins can also be used. A film that contains these materials will have excellent deep drawability, mold release properties, and releasability from a silicone-based material, and therefore a three-dimensionally shaped thermally conductive molded body can be produced with higher precision.

Representative embodiments of the present invention are described below in further detail to provide examples, but the present invention is not restricted to these embodiments.

The "three-dimensionally shaped part" of the present disclosure refers to a portion located higher than the bottom surface of the molded body in the three-dimensionally shaped thermally conductive molded body.

In the present disclosure, "substantially" includes variation caused by manufacturing error or the like, and a variation of approximately ±20% is considered permissible.

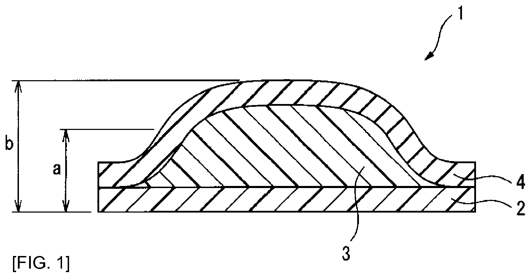

In the present disclosure, the term "domed" refers to being substantially round when viewed from above, and the lateral cross-sectional surface of a centerline of the substantially round shape is a substantially semicircular cross-sectional surface or the cross-sectional surface shown in FIG. 1, and indicates that either one of the outer side end parts of these cross-sectional surfaces can have a shape that can be further cut in the vertical direction from the bottom surface toward the inside (for example, along a first height a). In the present disclosure, the term "domed prism" indicates that a substantially rectangular shape or at least one end part with a substantially rectangular shape has a substantially semicircular shape or a substantially elliptical shape when viewed from above, and indicates that the lateral cross-section at a center position of the long side or long axis of the shape has a cross-section that is substantially a semicircular cross-section, or a cross-section as shown in FIG. 1, and either outer side in part of the cross-section can have a shape that can be further cut in the vertical direction from a bottom surface toward the inside (for example, along a first height a).

In the present disclosure, the term "bottom surface side" refers to being less than approximately half or approximately 1/3 or less of the maximum height of the three-dimensionally shaped part positioned higher than the bottom surface.

The three-dimensionally shaped thermally conductive molded body of the first embodiment of the present disclosure is a three-dimensionally shaped thermally conductive molded body containing a thermally conductive material and a silicone-based material, the molded body having a substantially flat bottom surface and a three-dimensionally shaped part located on the inside of the bottom surface, and the height of the three-dimensionally shaped part that is higher than the bottom surface differs in at least two locations. A three-dimensionally shaped thermally conductive molded body with this configuration may be the following "first three-dimensionally shaped thermally conductive molded body" or "first molded body".

FIG. 1 is a cross section view of a three-dimensionally shaped thermally conductive molded body according to the first embodiment of the present disclosure. As shown in FIG. 1, the three-dimensionally shaped thermally conductive molded body 1 includes a bottom part outer layer 2, middle member 3, and upper part outer layer 4, and the first height a and the second height b indicates that the height of the three-dimensionally shaped part higher than the bottom surface is different in at least 2 locations. Herein, if the silicone-based materials that are used in the bottom part outer layer 2, middle member 3, and upper part outer layer 4 are all the same, the three-dimensionally shaped thermally conductive molded body can be considered to have a single layer configuration, and if the silicone-based materials that are used in the bottom part outer layer 2 and the middle member 3, or the middle member 3 and the upper part outer layer 4, or the bottom part outer layer 2 and the upper part outer layer 4 are the same, the three-dimensionally shaped thermally conductive molded body can be considered to have a two layer configuration. If the upper part outer layer, middle member, and bottom part outer layer (including the case where a nonwoven material or the like is permeated with a silicone-based material) are formed by laminating in order in the manufacturing process of the molded body, each of the cured layers will be integrated using the same silicone-based material, and if the layer interface cannot be distinguished, the molded body can be considered to have a single layer configuration.

The silicone-based material is not particularly restricted, but can be a silicone gel or a silicone rubber. If the molded body has a laminate configuration, different types of silicone gels can be used, or a silicone gel and a silicone rubber can be used concomitantly. Silicone gel has excellent flexibility, and silicone rubber has excellent properties to prevent protruding from the end part.

Silicone gel

The silicone gel can be either a heat curing type or an ambient temperature curing type, and the curing mechanism can be either a condensation type or an addition type, or the like, but a silicone gel obtained from an addition type silicone composition is preferable from the perspective of easily achieving flexibility, or the like. The group bonded to the silicon atom is also not particularly limited, and examples thereof include an alkyl group such as a methyl group, ethyl group, propyl group, or the like, a cycloalkyl group such as a cyclopentyl group, cyclohexyl group, or the like, an alkenyl group such as a vinyl group, allyl group, or the like, an aryl group such as a phenyl group, tolyl group, and the like, and those groups in which hydrogen atoms have been partially substituted with other atoms or bonding groups.

The method of producing the addition reaction type (or crosslinking) silicone gel to be used in the present invention is not particularly limited, but usually an organohydrogen polysiloxane (a-1) and alkenyl polysiloxane (a-2) are used as raw materials, and both can be obtained by a hydrosilylation reaction (addition reaction) in the presence of a catalyst. The addition reaction curable silicone gel compositions that can form these silicone gels include two types, a one component curing type and a two component curing type, and a one component curing composition can provide a flexible gel by heating, and a two component curing composition can provide a flexible gel by heating after mixing the two components.

(a-3) Addition reaction catalyst

The addition reaction catalyst can be any catalyst that is known to promote an addition reaction (hydrosilylation reaction) between an alkyl group bonded to a silicon atom in the (a-1) component and a hydrogen atom bonded to a silicon atom in component (a-2). Examples include platinum-based catalysts such as chloroplatinic acid, alcohol-modified chloroplatinic acid, complexes of chloroplatinic acid and vinylsiloxane, a chloroplatinic acid and 2-ethylhexanol solution, and the like, palladium type catalysts such as tetrakis (triphenylphosphine) palladium, mixtures of palladium black and triphenylphosphine, and the like and platinum group metal type catalysts such as a rhodium catalyst or the like.

The amount of addition reaction catalyst added can be appropriately adjusted by considering the reactivity or the like, and the catalyst can be used in a range of approximately 0.1 ppm or more and approximately 100 ppm or less (calculated as catalyst metal element) with regard to the total amount of component (a-1) and component (a-2).

The flexibility of the silicone gel can be adjusted by changing the cross-linked density of the silicone gel by appropriately adjusting the formulation ratio of (a-1) through (a-3), the cross-linking temperature and time, and the like.

The desired viscosity of the silicone gel can be achieved by adding an MQ resin type viscosity increasing component, for example, or by adding a nonreactive adhesive component, or by adjusting the length of the side chains of non-cross-linking functional groups and the type of terminal functional groups, and the like.

Silicone rubber

The silicone rubber can be either an addition reaction type or a condensation type. The addition reaction type silicone rubber can be a silicone rubber that exhibits rubber elasticity (properties that elongate when a load is applied and return to substantially the original position when the load is removed) by increasing the cross-linking density of the aforementioned addition reaction type silicone gel. A condensation type silicone rubber is one that cross-links by a hydrolytic condensation reaction by reacting with the moisture in the atmosphere. Examples of hydrolytic functional groups of a condensation type reactive silicone rubber include alkoxy groups (dealcohol type), isopropenoxy groups (deacetone), methyl ethyl ketoxime groups (deoxime type), acetoxy groups (deacetylation type), and the like, but a deacetone type or dealcohol type is preferable from the perspective that the curing rate is fast, and for minimizing the odor of the released substance.

Thermally conductive material

The thermally conductive material can be electrically conductive or can be electrically insulating. Examples of insulating thermally conductive materials include nitrogen compounds such as boron nitride, aluminum nitride, silicon nitride, and the like, metal oxides such as aluminum oxide (alumina), magnesium oxide, zinc oxide, silicon oxide, beryllium oxide, titanium oxide, copper oxide, copper I oxide, and the like, metal hydroxides such as magnesium hydroxide, aluminum hydroxide, and the like, carbon compounds such as magnesite (magnesium carbonate), silicon carbide, diamond, and the like, ceramics such as silica, talc, mica, kaolin, bentonite, pyroferrite, and the like, titanium boride, calcium titanate, and the like.

Of these, aluminum oxide (alumina), aluminum hydroxide, zinc oxide, boron nitride, and aluminum nitride are preferable from the perspective of thermal conductivity and the like. The boron nitride can have any structure such as C-BN (cubic structure), w-BN (wurtzite structure), h-BN (hexagonal structure), r-BN (rhombnohedral structure), t-BN (turbostratic structure), and the like. The shape of the boron nitride includes scale shaped, aggregates thereof, and the like, but any shape can be used.

Examples of electrically conductive and thermally conductive materials include carbon compounds such as graphite, carbon black, graphite, carbon fibers (pitch type, PAN type), carbon nanotubes (CNT), carbon nanofibers (CNF) and the like, metals such as silver, copper, iron, nickel, aluminum, titanium, and the like, as well as metal alloys containing these metals, conductive metal oxides such as stainless steel (SUS), zinc oxide doped with various types of elements, and the like, and metallic compounds such as ferrites, and the like. An insulating material such as silica or the like can be made conductive by coating with an electrically conductive heat conducting material, or an insulative type can be made by coating an insulating material such as silica or the like onto an electrically conductive and thermally conductive material, and these can be used as thermally conductive materials.

These thermally conductive materials can be used individually, or two or more types can be combined and used. Various shapes of the thermally conductive materials can be used, and examples include fiber shape, plate shape, scale shape, rod shape, granular shape, rod shape, tube shape, curved shape, needle shape, curved shape, needle shape, and the like. These thermally conductive materials can be surface treated by silane coupling treatment, titanate coupling treatment, epoxy treatment, urethane treatment, oxide treatment, and the like.

The total amount of the thermally conductive material in the three-dimensionally shaped thermally conductive molded body depends on the type of the thermally conductive material, but can be approximately 30 mass % or higher, approximately 50 mass % or higher, or approximately 80 mass % or higher and approximately 95 mass % or lower, or approximately 90 mass % or lower. Based on a volumetric ratio, if the molded body has a laminate configuration, the total amount of the molded body is limited to the aforementioned range, and the amount in each layer can be outside the aforementioned range, and the amount of each layer can be the same or different.

The heat dissipating performance of the three-dimensionally shaped thermally conductive molded body of the present disclosure (thermal conductivity) can be approximately 1.00 W/mK or higher, or approximately 1.20 W/mK or higher. This value is a value that includes the surface thermal resistance.

The average particle size of the thermally conductive material can be approximately 0.1 μm or more, approximately 0.2 μm or more, or approximately 0.3 μm or more, and approximately 200 μm or less, approximately 100 μm or less, and approximately 70 μm or less. The thermally conductive materials can be two or more types of particles with different average particle size. With the aforementioned configuration, the thermally conductive material with a smaller particle size can embed between the large particle diameters in order to fill in a condition that achieves maximum density filling in order to increase the thermal conductivity. The average particle size and particle size distribution of the thermally conductive material can be measured by an electron microscope, laser diffraction light scattering device, or the like. For example, if two particles with different average particle sizes are concomitantly used, two peaks will be measured in the particle size distribution for the silicon-based material containing these particles. Therefore, the number of types of particles with different average particle sizes included in the silicone-based material can be confirmed by checking the number of peaks in the particle size distribution of the silicone-based material.

The silicone-based material may also contain additives such as flame retardants, pigments, dyes, fillers, reinforcing materials, leveling agents, defoaming agents, dispersing agents, curing accelerators, reactive diluents, solvents and the like. The added amounts of these additives can be appropriately determined within a range that does not impede the effect of the present invention.

The middle member of the three-dimensionally shaped thermally conductive molded body can have a hardness of approximately 30 or less, approximately 20 or less, or approximately 8 or less, and approximately 0 or higher, as measured by an Asker C hardness meter when the middle member is formed as a sheet with a thickness of approximately 10 mm.

The three-dimensionally shaped thermally conductive molded body can have a one layer, two layer, or three layer configuration. For a one layer configuration, the entire body is preferably made of silicone gel, from the perspective of achieving the desired flexibility. With a two layer configuration, any two of the bottom part outer layer 2, middle member 3, and upper part outer layer 4 can be made of the same silicone gel, and the remaining can be made of a different silicone gel or a silicone rubber, or the bottom part outer layer 2 and the upper part outer layer 4 can be made of the same silicone rubber, and the middle member 3 can be made of a silicone gel. The upper part outer layer 4 or the upper part outer layer 4 and the bottom part outer layer 2 are preferably made of silicone rubber, from the perspective of flexibility and preventing protrusion from the end parts. With a 3 layer configuration, the bottom part outer layer 2, middle member 3, and the upper part outer layer 4 can all be made from various different silicone-based materials. Similar to a two layer configuration, the upper part outer layer 4 or the upper part outer layer 4 and the bottom part outer layer 2 are preferably made of silicone rubber, from the perspective of flexibility and preventing protrusion from the end parts. With a molded body having a two layer or three layer configuration, the middle member 3 will be more flexible than the upper part outer layer 4 and/or the bottom part outer layer 2, and will have excellent properties for preventing protrusion from the end part. Of these, with a molded body with a two layer or three layer configuration that uses silicone rubber in the upper part outer layer 4, or in the upper part outer layer 4 and the bottom part outer layer 2, the middle member 3 will be covered by at least an upper part outer layer 4 made of silicone rubber even if a silicone-based material with high flexibility that can protrude from the end part is used as the middle member, and therefore the middle member will not easily leak from the end part because of the recovery force of the silicone rubber.

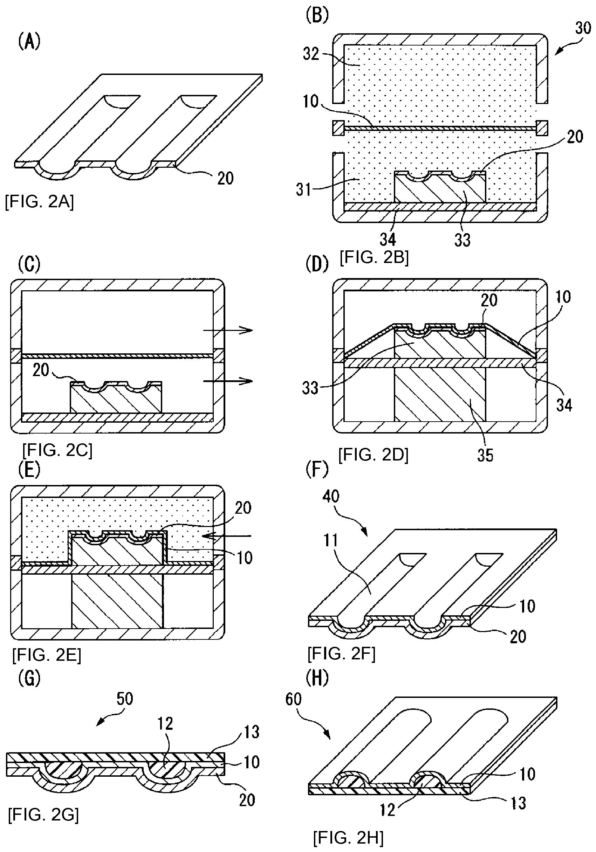

The three-dimensionally shaped part higher than the bottom surface of the three-dimensionally shaped thermally conductive molded body is not particularly restricted, so long as having a different height in at least two locations or in three locations. Of these, the three-dimensionally shaped part preferably has a substantially domed shape or substantially dome prism shape as shown in FIG. 1 and 2. With this configuration, if the surface of the adherend can be used is flat, the apex of the substantially dome shape or substantially dome prism shape will first adhere to the flat surface of the adherend, and then the three-dimensionally shaped part of the molded body will be smashed and deformed with pressing, and the air between the adherend and the three-dimensionally shaped part will be pushed to the outside, so the three-dimensionally shaped part will lead hereto the flat surface of the adherend from the apex moving toward the outside, and therefore air will not be incorporated between the adherend and the three-dimensionally shaped part, and thus the contact surface area of the three-dimensionally shaped thermally conductive molded body to the adherend can be increased. These effects will be demonstrated if the upper part outer layer contains a silicone-based material, but if another plastic material with inferior flexibility is used, air will become incorporated even if with the same three-dimensionally shaped part, and sufficient contact surface area will not be achieved.

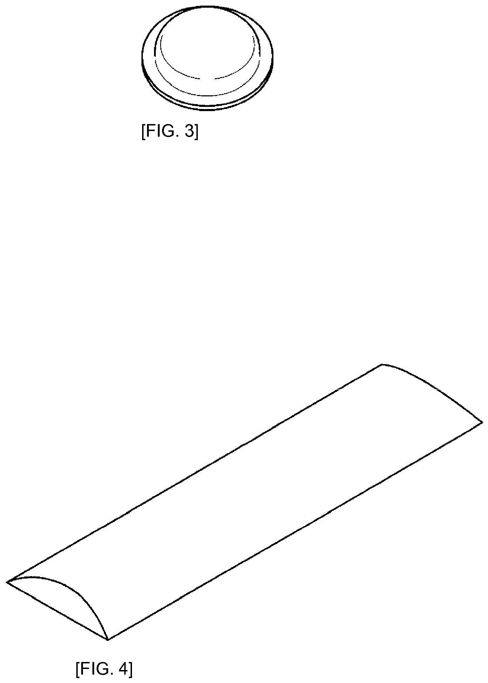

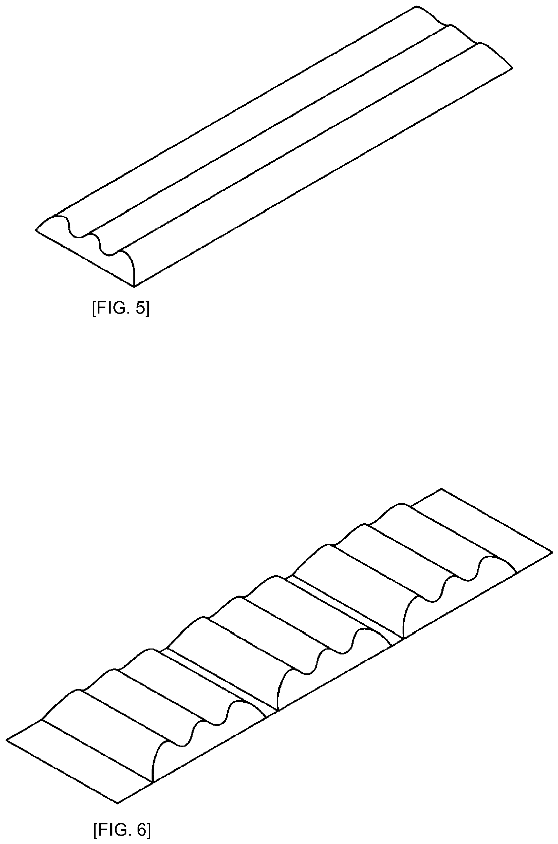

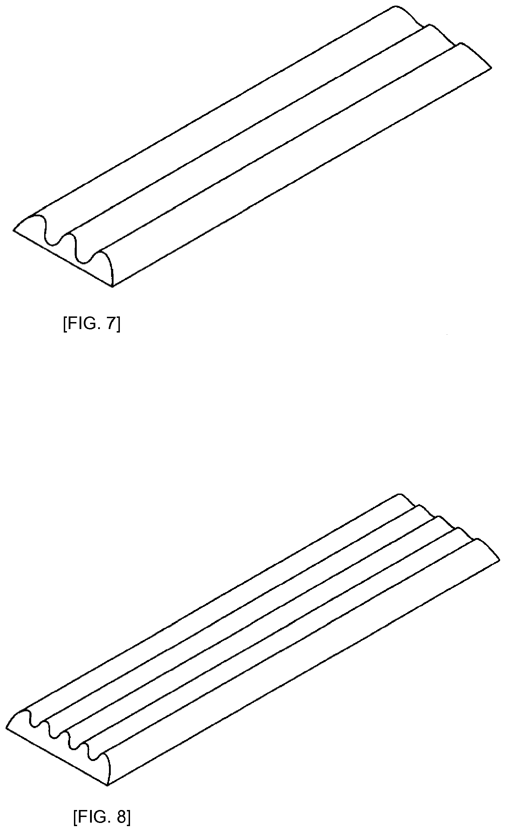

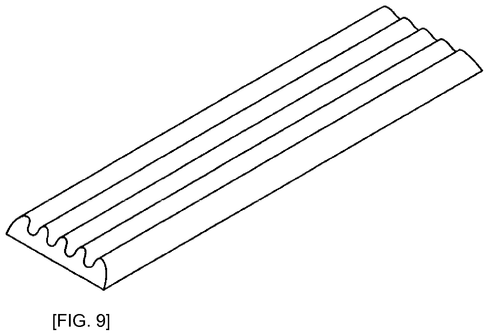

FIG. 3 to FIG. 9 show examples of specific shapes of a three-dimensionally shaped thermally conductive molded body, but the shape of the molded body is not restricted to these shapes. The molded bodies in FIG. 3 to FIG. 9 have a three-dimensionally shaped part with a substantially domed shape or a substantially domed prism shape, and thus the air removing properties are favorable compared to a conventional flat sheet shaped thermally conductive molded body. Of these, molded bodies that were larger and molded bodies with a plurality of three-dimensionally shaped parts, specifically two or more, three or more, or five or more, can further reduce defects do to incorporation of air (bubbles) at the contact part between the heatsink and heat generating components such as heat generating elements and the like. The size, quantity, placement position, and the like of the three-dimensionally shaped parts in the molded body can be appropriately set by considering the shape, size, and the like of the components that apply the molded body, and coexistence of a substantially domed three-dimensionally shaped part and a substantially dome prism shaped three-dimensionally shaped part is acceptable.

The three-dimensionally shaped thermally conductive molded body of the present disclosure has a configuration where the height of the three-dimensionally shaped parts higher than the bottom surface differ in at least two locations, and therefore the stress that is applied to the various types of components being applied can be reduced as compared to a conventional flat sheet shaped thermally conductive molded body.

Specifically, if the height of the three-dimensionally shaped part is a reference, the load when the height is compressed to 80% (load under 20% compression), for example, will be smaller than the load when a thermally conductive molded body with a flat sheet shape is used and compressed at the same ratio. The load during 20% compression can be approximately 95% or lower, approximately 90% or lower, or approximately 85% or lower, as compared to a conventional flat sheet shaped thermally conductive molded body.

If the application surface of the adherend to which the three-dimensionally shaped thermally conductive molded body is applied is irregularly shaped rather than substantially flat, the three-dimensionally shaped part of the molded body may have a shape that essentially matches the shape of the adherend. For example, the stress on each element can be minimized, and the contact surface area can be maximized by molding based on the shape of each element on the substrate using a thermally conductive molded body that covers the entire electronic substrate. Furthermore, even if the adherend is a coil, for example, the coil can easily be encircled by the three-dimensionally shaped thermally conductive molded body without gaps using a three-dimensionally shaped part with a coil cutout shape.

The size of the three-dimensionally shaped thermally conductive molded body can be appropriately determined based on the adherend to be applied. If the three-dimensionally shaped thermally conductive molded body has a laminate configuration, the thickness of the upper part outer layer and the bottom part outer layer can be approximately 10 $\mu$m or more or approximately 50 $\mu$m or more, and approximately 500 $\mu$m or less or approximately 300 $\mu$m or less, when considering the flexibility, properties for preventing protrusion from the end part, strength, and the like.

The three-dimensionally shaped thermally conductive molded body may contain a reinforcing substrate such as a woven material, knitted material, or nonwoven material, or the like in the bottom surface side in a manner that prevents exposure from the bottom surface of the molded body. If a reinforcing substrate is present on the bottom surface side of the molded body, stretching of the molded body in a planar direction can be suppressed, the strength of the molded body will be increased, and defects such as cracking and the like when the molded body is removed from the mold can be prevented. Of these, a nonwoven material is preferable because the permeability of the silicone-based material will be excellent. The nonwoven material can be retained by a silicone-based material between the component fibers simply by impregnating with the silicone-based material and therefore an equivalent or higher strength than these reinforcing materials can be achieved even if the nonwoven material is thinner than the reinforcing substrate made of a woven material or knit material. The material of the reinforcing substrate can be glass, vinylon, aramid, nylon, polyolefin, polyester, acrylic, and the like, but glass is preferable because flame retardancy can be imparted. The thickness of the nonwoven material can be approximately 20 μm or more or approximately 40 μm or more, or can be thinner than approximately 0.2 mm, or thinner than approximately 0.1 mm.

With the three-dimensionally shaped thermally conductive molded body, the tackiness of the bottom surface and the surface portion of the molded body excluding the bottom surface can be different. This molded body having tackiness will adhere to either adherend without breaking during rework, and therefore the rework operation can easily be performed. The tackiness of the three-dimensionally shaped thermally conductive molded body can be appropriately adjusted by surface treatment, using different types of materials such as silicone rubber and silicone gel and the like, and by the difference in the amount of adhesive components.

The method of manufacturing the three-dimensionally shaped thermally conductive molded body of the present disclosure will be described as an example, but the method of manufacturing the three-dimensionally shaped thermally conductive molded body is not restricted to these. For example, in the following method, a method employing a vacuum heat and compression bonding device is described for overlaying on an extensible film, but the method is not limited to this method, and a vacuum molding method, a film insert molding method, or the like can also be used.

The method of manufacturing the three-dimensionally shaped thermally conductive molded body 60 can manufacture using the following method, for example (FIGS. 2A to 2H).

The upper part outer layer is formed by applying and curing a first silicone-based material containing a thermally conductive material, on the extensible film of a laminate film containing an extensible film and a release film. Curing can be performed by thermal curing, electron beam curing, or the like, but there is no limitation in particular.

As shown in FIG. 2A, a mold 20 with a predetermined three-dimensional shape is prepared. As shown in FIG. 2B, an exemplary vacuum heat and compression bonding device 30 has a first vacuum chamber 31 and a second vacuum chamber 32 vertically positioned, and a jig where an upper part outer layer laminate film 10 is overlaid on a mold 20 is provided between the upper and lower vacuum chambers. Furthermore, a partition plate 34 and a pedestal 33 are provided on a raising and lowering table 35 (not illustrated in the drawings) that can vertically raise and lower in the lower first vacuum chamber 31, and a mold 20 is set on this pedestal 33. This type of vacuum heat and compression bonding device can be a commercial product, and for example, can be a double-sided vacuum molding machine (manufactured by Fuse Vacuum Forming) or the like.

As illustrated in FIG. 2B, first, an upper part outer layer laminate film 10 with an extensible film from which a release film was removed and an upper part outer layer is set such that the extensible film is on the mold 20 side, in a condition where the first vacuum chamber 31 and the second vacuum chamber 32 of the vacuum heating and compression bonding device are open to atmospheric pressure. The mold 20 is set on the pedestal 33 in the first vacuum chamber 31.

Next, as shown in FIG. 2C, the first vacuum chamber 31 and the second vacuum chamber 32 are closed and depressurized to form a vacuum in each chamber (approximately 0 atm assuming atmospheric pressure is 1 atm). Next, or at the same time as forming the vacuum, the upper part outer layer laminate film 10 is heated. Next, as shown in FIG. 2D, the raising and lowering table 35 is raised such that the mold 20 is pushed up to the second vacuum chamber 32. Heating can be performed by a lamp heater, for example, that is installed in a ceiling part of the second vacuum chamber 32. The heating temperature is generally approximately 50°C or higher or approximately 130°C or higher, and approximately 180°C or lower or approximately 160°C or lower. The degree of vacuum of the reduced pressure environment can be approximately 0.10 atm or less, approximately 0.05 atm or less, or approximately 0.01 atm or less, when atmospheric pressure is 1 atm.

The heated upper part outer layer laminate film 10 is stretched by pressing to the surface of the mold 20. Next, or at the time of stretching, as shown in FIG. 2E, the inside of the second vacuum chamber 32 is pressurized to an appropriate pressure (for example, 3 atm to 1 atm). The heated upper part outer layer laminate film 10 adheres to the exposed surface of the mold 20 due to the pressure difference, tracks and stretches to the three-dimensional shape of the exposed surface, and forms a coating on the surface of the mold 20 in a releasably adhered condition. After reducing the pressure and heating are performed in the condition of FIG. 2C, the inside of the second vacuum chamber 32 is pressurized in this condition, and the exposed surface of the mold 20 can be covered by the upper part outer layer laminate film 10.

Next, the upper and lower first vacuum chamber 31 and the second vacuum chamber 32 are again released to atmospheric pressure, and the mold 20 that is covered by the upper part outer layer laminate film 10 is removed to the outside. As shown in FIG. 2F, an edge of the upper part outer layer laminate film 10 that is adhered to the surface of the mold 20 is trimmed to provide an integrated product 40 with the upper part outer layer laminate film 10 and the mold 20.

Next, a second silicone-based material containing thermally conductive material is filled into a hollow part 11 of the integrated product 40, and if necessary, smoothing is performed using a blade or the like, to form the middle member 12. In this stage, the second silicone-based material is cured and removed from the integrated product 40, and if necessary, the extensible film is removed, and a punching process is performed to obtain the three-dimensionally shaped thermally conductive molded body. In the embodiment of FIGS. 2A to 2H, as shown in FIG. 2G, a configuration for also applying the bottom part outer layer 13 onto the middle member 12 is illustrated. With this embodiment, the bottom part outer layer 13 is formed by applying a third silicone-based material containing a thermally conductive material onto the release film (not illustrated in the drawings) and placing the release film containing the bottom part outer layer 13 such that the release film containing the bottom part outer layer 13 is the outermost layer, such that the bottom part outer layer 13 covers the upper part outer layer laminate film 10 and the middle member 12 that is filled in the hollow part 11 to obtain the final integrated product 50. Herein, when forming the bottom part outer layer 13 on the release film, a reinforcing substrate such as a nonwoven material or the like can be applied onto the release film, a third silicone-based material is applied and permeated into the substrate so as to obtain the bottom part outer layer 13. If necessary, a smoothing process using a blade, rubber roller, or the like is performed on a portion located on the bottom surface side of the molded body, and then the second and third silicone-based materials that formed the middle member 12 and the bottom part outer layer 13 are cured. Curing of the middle member 12 and curing of the bottom part outer layer 13 are preferably performed at the same time, from the perspective of adhesion. Curing can be performed by various types of curing methods, such as thermal curing, electron beam curing, and the like.

The final integrated product 50 is optionally cooled, and the three-dimensionally shaped thermally conductive molded body with an extensible film and an optional release film if present can be removed from the mold 20 to obtain a three-dimensionally shaped thermally conductive molded body 60. If necessary, the extensible film and the release film can be removed, and the upper part outer layer portion and the bottom part outer layer portion if present are appropriately punched out without including the middle member, and thus individual three-dimensionally shaped thermally conductive molded bodies can be obtained.

If all of the first through third silicone-based materials including the thermally conductive material are all the same material, the molded body can be considered to have a one layer configuration, and if two types of the three types are the same material, the molded body can be considered to have a two layer configuration, and if all three types are different materials, the molded body is considered to have a three layer configuration.

A single layer configuration three-dimensionally shaped thermally conductive molded body can be manufactured using the following method, for example.

An extensible film is set on the vacuum heating and compression device 30 instead of the upper part outer layer laminate film 10, and the extensible film is releasably overlaid on the mold 20 by the aforementioned method to obtain an integrated product 40 including an extensible film and the mold 20.

Next, a silicone-based material containing thermally conductive material is filled into a hollow part 11 of the integrated product 40, and if necessary, smoothing process is performed using a blade or the like, and the silicon-based material is cured.

After optionally cooling the mold, the three-dimensionally shaped thermally conductive molded body with an extensible film can be removed from the mold to obtain a three-dimensionally shaped thermally conductive molded body with a one layer configuration. If necessary, the extensible film can be removed, and an appropriate punch out step is performed to obtain individual three-dimensionally shaped thermally conductive molded bodies.

The extensible film that is used with the method of manufacturing a three-dimensionally shaped thermally conductive molded body is not particularly limited so long as having elasticity such that deep draw molding is possible, for example, and having mold release properties and release properties towards the silicone-based material, and polyolefin resins such as polyethylene (for example, low density polyethylene resins, medium density polyethylene resins), polypropylene and polyethylene copolymers, and the like, polymethylpentene resins (TPX (registered trademark) resin), ionomer resins, and fluorine resins, and the like, and at least one type or more of these resins can be used. These materials can be used individually or in combination, and can be used in the form of a single layer film or a laminate film. A surface treatment such as a mold release treatment or the like can also be appropriately applied to the film surface.

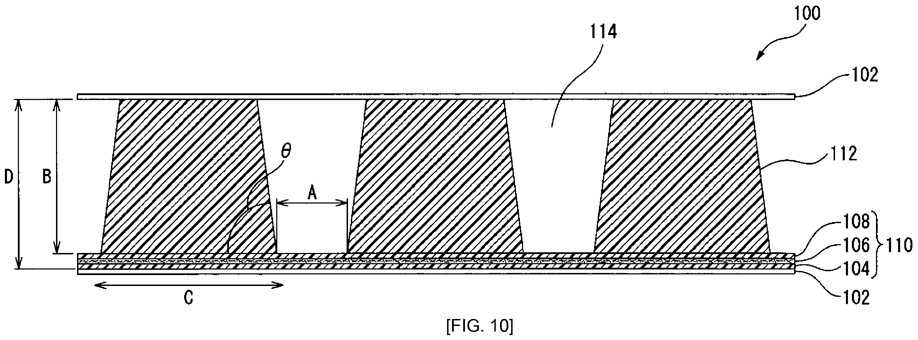

An example of a three-dimensionally shaped thermally conductive molded body of another embodiment of the present disclosure (hereinafter also referred to as the "second three-dimensionally shaped thermally conductive molded body" or "second molded body") is shown in FIG. 10, 11, 13, and 14. The three-dimensionally shaped thermally conductive molded body has a plurality of protruding layers and a bottom part outer layer, wherein

the protruding layer includes a thermally conductive material and a silicone-based material;

the bottom part outer layer includes a thermally conductive material, a silicone-based material, and a reinforcing base;

the protruding layers arranged to provide a gap between adjacent protruding layers such that the bottom surface outer circumferential parts of adjacent protruding layers do not contact; and

the following Equation (I) is satisfied

[Equation 3]

$$\alpha Y = 100 - X \ (I)$$

[in the equation, α is approximately 0.70 to approximately 1.00, X is the compression ratio (%) when the gap is completely filled by compression deforming of the protruding layer, and Y is the ratio (%) of the total area of the bottom part outer layer upper surface occupied by the total surface area of the protruding layer bottom surface].

The thermally conductive material, silicone-based material, and the reinforcing substrate can be the aforementioned materials that are used in the protruding layer and the bottom part outer layer of the second three-dimensionally shaped thermally conductive molded body. With this molded body, silicone gel is preferably used as the silicone-based material from the perspective of stress relaxation, contact surface area, tracking of recesses and protrusions, and the like.

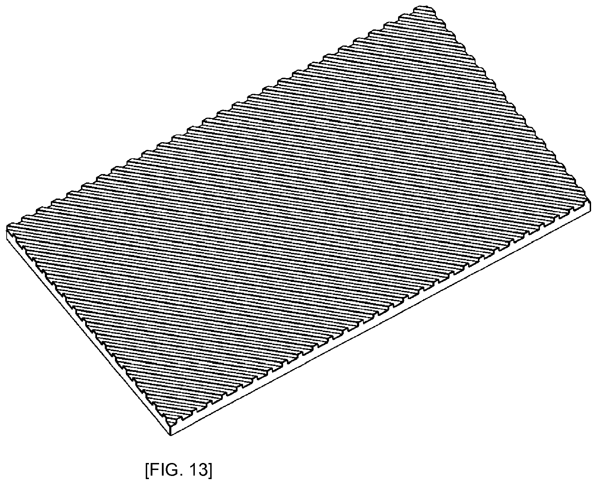

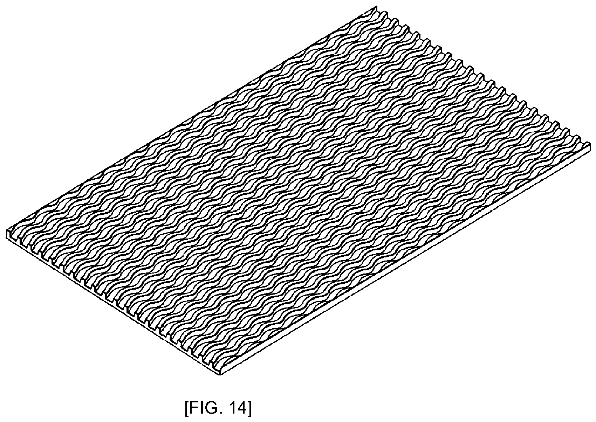

The protruding layers of the second three-dimensionally shaped thermally conductive molded body are provided such that a gap is provided between adjacent protruding layers, without contacting the bottom surface outer circumferential part of the adjacent protruding layer, as illustrated in FIG. 10, 11, 13, and 14. The protruding shape of the protruding layer is not limited to the following shapes, but can be at least one type selected from a substantially columnar shape, a substantially prismatic shape, a substantially truncated cone shaped, or a substantially truncated pyramid shape. In addition, as illustrated in FIG. 13 and FIG. 14, for example, the protruding layers (hereinafter, these protruding layers are also referred to as "substantially straight line protruding layer", "substantially wavy line protruding layer", and "substantially zigzag shaped protruding layer") provided in a substantially straight line, a substantially wavy shape, or a substantially zigzag shape with regard to the main surface of the bottom part outer layer, and the cross-sectional shape when the protruding layer is vertically cut with regard to the bottom part outer layer, can be a substantially square shape, a substantially rectangular shape, or a substantially isosceles trapezoidal shape, or the like. The substantially straight line protruding layer, substantially wavy protruding layer, or substantially zigzag shape protruding layer can have a continuous shape or can be continuously molded as illustrated in FIG. 13 and FIG. 14. For example, with a three-dimensionally shaped thermally conductive molded body as illustrated in FIG. 13 or FIG.14, if one side of the molded body is the x-axis, one side perpendicular to the x-axis is the y-axis, and the thickness direction of the molded body is the z-axis, the straight line shaped protruding layer, the substantially wavy protruding layer, or these substantially zigzag shaped protruding layer can be formed to be substantially parallel to the x-axis (substantially perpendicular to the y-axis), can be formed to be substantially parallel to the y-axis (substantially vertical to the x-axis), or can be substantially formed at an angle to the x-axis or the y-axis. Herein, "wavy" refers to a smooth wavy condition such as a sine wave, and "zigzag shape" refers to a shape with sharp bends like a saw tooth blade. The protruding layer preferably is a substantially prismatic protruding layer, substantially truncated cone shaped protruding layer, substantially straight line protruding layer, or substantially wavy protruding layer, from the perspective of increasing the contact surface area to the adherend. The upper surface of the protruding layer may have a substantially domed shape as described above, but a substantially flat plane surface is preferable from the perspective of increasing the contact surface area to the adherend. The shape of the flat plane surface can be a substantially circular shape, a substantially equilateral triangle shape, a substantially square shape, a substantially regular pentagon shape, a substantially regular hexagon shape, a substantially rectangular shape, or a substantially wavy shape. The shape of the flat plane surface can be a substantially equilateral triangle shape, a substantially square shape, a substantially regular pentagon shape, a substantially regular hexagon shape, a substantially rectangular shape, or a substantially wavy shape, from the perspective of increasing the contact surface area to the adherend, and the protruding layer with the shape of the flat plane surface can have a cross-sectional part along each leg of the shape of the flat plane surface, and each adjacent leg of the shape of the flat plane surface of adjacent protruding layers preferably has a flat planar shape. The protruding layer with this configuration easily fills in adjacent gaps by the portion that expands in the horizontal direction after compression (hereinafter also referred to as the "expanding part"), and a uniform contact surface with few voids can more easily be formed on the adherend application surface.

The protruding layer is formed so as to satisfy the following equation (I), and the second molded body can increase the contact surface area to the adherend while having excellent stress relaxation toward the adherend.

[Equation 4]

$$\alpha Y = 100 - X \ (I)$$

[in the equation, α is approximately 0.70 to approximately 1.00, X is the compression ratio (%) when the gap is completely filled by compression deforming of the protruding layer, and Y is the ratio (%) of the total area of the bottom part outer layer upper surface occupied by the total surface area of the protruding layer bottom surface.]

α represents a coefficient that varies depending on the material that forms the protruding layer and the compression ratio, and for example, α can be calculated by the following experiment. First, a sheet having a predetermined thickness is punched out with a punch having a diameter of 4.3 mm to prepare a cylindrical sample. The diameter (initial diameter) of the upper surface prior to compression of the cylindrical sample and the cylinder maximum diameter after pressing and smashing downward from the upper surface, using a glass plate or the like to compress the cylindrical sample to 1 mm (diameter after compression) is measured. Herein, the cylinder maximum diameter refers to the diameter of the round portion that is spread out the farthest in the lateral direction between the upper surface of the cylindrical sample to the bottom surface. The surface area of the round portion of the cylindrical sample before and after compressing are calculated from the measured diameters, and the surface area ratios before and after compression are calculated, corresponding to the aforementioned Y (%) (upper surface part surface area before compression/maximum surface area after compression). Subsequently, the compression ratio (1 mm/initial thickness (mm) of the cylindrical sample) when the cylindrical sample is compressed by 1 mm is calculated, corresponding to the above X (%). The values for X and Y are introduce to the following equation (II) in order to calculate $\alpha$.

[Equation 5]

$$\alpha = (100-X)/Y \ (II)$$

As an example, the results for $\alpha$ calculated for cylinder samples 1 to 3 are shown in Table 1 as an example.

[Table 1]

| No. | Initial thickness (mm) | Initial diameter (mm) | Diameter after compression (mm) | Y(%) | X(%) | $\alpha$ |
|---|---|---|---|---|---|---|
| 1 | 2.6 | 4.3 | 5.13 | 70.3 | 38.5 | 0.88 |
| 2 | 2.1 | 4.3 | 5.64 | 58.1 | 47.6 | 0.90 |
| 3 | 1.6 | 4.3 | 6.80 | 40.0 | 62.5 | 0.94 |

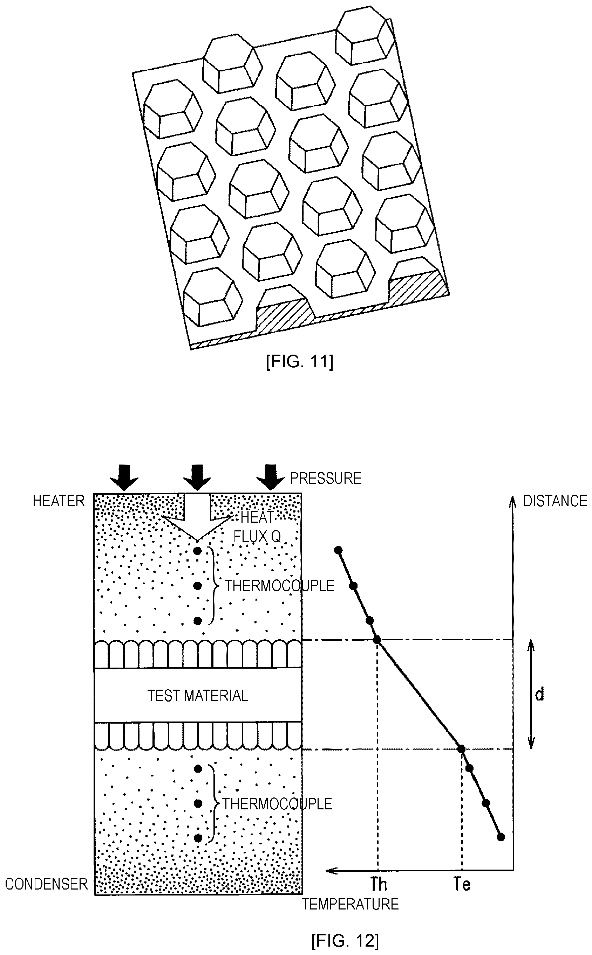

$\alpha$ can be within the range of approximately 0.70 or higher, approximately 0.72 or higher, approximately 0.75 or higher, approximately 0.77 or higher, approximately 0.80 or higher or approximately 0.82 or higher, and approximately 1.00 or lower. X is the compression ratio (%) when the gap is completely filled by compression deformation of the protruding layer and is not limited to the following range, but it is approximately 20% or more, approximately 25% or more or approximately 30% or more, approximately 75% or less, and approximately 70% or less or approximately 65% or less. Y is the ratio (%) of the total area of the bottom surface of the protrusion layer to the total area of the upper surface of the bottom part outer layer. A method of determining Y in a three-dimensionally shaped thermally conductive molded body having a plurality of protruding layers is to display a sheet of the three-dimensionally shaped thermally conductive molded body with a size of at least 1 m x 1 m (1 m$^2$) on a personal computer while referencing the mold data for obtaining the three-dimensionally shaped thermally conductive molded body, calculating the surface area A of the bottom surface of the protruding layer of the sheet, and determining Y (%) from the equation (surface area A x 100)/(total surface area (1 m$^2$)) of the sheet upper surface excluding the protruding layer). Naturally, the sheet of the three-dimensionally shaped thermally conductive molded body with a size of at least 1 m x 1 m may be an actual sheet. Alternatively, for example, in the case of a three-dimensionally shaped thermally conductive molded article having a hexagonal prism protruding layer exemplified in FIG. 11, one hexagonal prism is arbitrarily selected from among a plurality of hexagonal prisms, and the diameter of a circumscribed circle (C) of the regular hexagon which is the bottom surface of the hexagonal prism (hereinafter, also referred to as "inside regular hexagon") is measured. Next, a regular hexagon (hereinafter also referred to as "outside regular hexagon") with a size that is only half of the with of the gap (A) from each leg of the inside regular hexagon is derived, and the diameter of the circumscribed circle of the outside regular hexagon is determined (C + A). Based on the diameter of each circumscribed circle, the areas of the inside regular hexagons and the outside regular hexagons can be calculated, and Y (%) can be determined from the equation (area of the inside regular hexagon x 100)/(area of the outside regular hexagon). The value of Y determined by this method is derived from the minimum unit of one protruding layer, and when the shape and size of the protruding layer and the shape and size of the gap are substantially equal, the value of Y can be determined by this method.

The taper angle ($\theta$) of the protruding layer can be approximately 80° or more or approximately 82° or more, and approximately 90° or less or approximately 88° or less. The protruding layer will have excellent mold release properties, and a uniform contact surface with fewer voids can more easily be formed on the adherend application surface after compression. Herein, the taper angle ($\theta$) of the protruding layer refers to the angle that is formed by the cross-section along each side of the flat plain shape of the upper surface of the protruding layer and the upper surface of the bottom part outer layer as illustrated in FIG. 10.

The protruding layer has a hardness as determined by an Asker C hardness meter of approximately 30 or lower, approximately 20 or lower or approximately 10 or lower, and approximately 0 or higher, for the case where a sheet with a thickness of approximately 10 mm is formed of the material that forms the protruding layer. A protruding layer with an Asker hardness within this range will have excellent flexibility, and will have enhanced void filling properties, increased contact surface area to the adherend, and excellent recess and protrusion following properties, inconjuction with compression.

The second three-dimensionally shaped thermally conductive molded article can have 5 or more protruding layers per square inch, 10 or more protruding layers per square inch, or 12 or more protruding layers per square inch. A molded body with this configuration can express sufficient heat dissipating properties towards the adherend.

The maximum height from the upper surface of the bottom part outer layer to the upper surface of the protruding layer can be approximately 0.5 mm or more or approximately 1.0 mm or more, and approximately 3.5 mm or less or approximately 3.0 mm or less.

The gap 114 formed between the protruding layers in the second three-dimensionally shaped thermally conductive molded body has the width A at the bottom surface of the gap as exemplified in FIG. 10, and therefore the second molded body of the present disclosure will have excellent tear resistance compared to a molded body with a gap such as a V-shaped groove without providing this width. When comparing the molded body (the former form) in which the protruding layer is applied so as to have the gap of the present disclosure with the molded body (the latter form) in which the protruding layer is applied so as to have a gap such as a V-shaped groove, adjacent protruding layers are close to each other in the latter form, and the protruding layer portion that can be compressed and expanded in the horizontal direction is smaller than the former form, so that the protruding layer can be compressed in a smaller ratio. As a result, although the size of the recesses and protrusions of the adherend to be applied is limited in the latter form in which the ratio at which the protruding layer can be compressed is low, in the former form of the present disclosure, the ratio that the protruding layer can be compressed and the degrees of freedom of recesses and protrusion tracking is increased as compared to the latter form, so that there is an advantage that the range of selection of usable adherends is increased. The width of the gap is preferably substantially uniform from the perspective that a uniform contact surface with fewer voids can more easily be formed on the adherend application surface.

As shown in FIG. 10, the bottom part outer layer of the second three-dimensionally shaped thermally conductive molded body has a laminated structure including a reinforcing base material layer 106 such as a nonwoven fabric or the like, between the silicone material layers (104,108), and an integrated configuration where the silicone-based material is permeated into the reinforcing substrate is also acceptable. When a composition containing the silicone-based material that is used in the bottom part outer layer and the thermally conductive material is the same composition that was used in the protruding layer, the second three-dimensionally shaped thermally conductive molded body having a protruding layer and a bottom part outer layer can be considered an integrated product. The bottom part outer layer in this case can be the portion located on the lower side of the cross-section in the bottom surface direction of the gap (however, a release film is excluded if present).

A conventional flat heat dissipating sheet generates compressive stress in the compressed surface during compression in conjunction with application to the adherend (for example, an IC chip or the like) of the sheet, and generates tensile stress which is the reaction in the planar direction in the vicinity of the adherend. There is a possibility that the adherend could be damaged by these stresses, so a heat dissipating sheet with a recess and protrusion shape is being developed in order to relax these stresses. However, these conventional heat dissipating sheet use materials with inferior flexibility in order to maintain the recess and protrusion shape, and therefore void parts are produced corresponding to the recesses in the heat dissipating sheet and contact surface area is reduced, and as a result, the heat dissipating properties may be reduced. The second three-dimensionally shaped thermally conductive molded body of the present disclosure includes a reinforcing substrate such as a nonwoven material or the like in the bottom part outer layer, and therefore the tearing strength or the like of the molded body can be increased, so it is possible to use only silicone gel as the silicone material used in the molded body that is more flexible than silicone rubber, and that has excellent gap filling properties and recess and protrusion tracking properties, and therefore the contact surface area to the adherend after compression can be further increased and the heat dissipating properties can be further enhanced as compared to a conventional heat dissipating sheet with recesses and protrusions.

When adopting a bottom part outer layer without the reinforcing substrate, if rework is performed after applying the molded body between two adherend members, and then compressing and overlaying, peeling can occur from the bottom part outer layer side or from the protruding layer side, and the molded body can be damaged in some cases. However, the second molded body of the present disclosure has a bottom part outer layer with a reinforcing substrate, and therefore when performing rework, the molded body can be peeled from the protruding layer side in a condition where the bottom part outer layer is overlaid on the adherend, and therefore there is an advantage that reworkability will be excellent. The tensile adhesive strength of the second molded body is preferably approximately 14 N/cm$^2$ or less, approximately 12 N/cm$^2$ or less, or approximately 10 N/cm$^2$ or less, from the perspective of reworkability.

The thickness of the bottom part outer layer can be approximately 0.5 mm or less or approximately 0.4 mm or less, and approximately 0.05 mm or more or approximately 0.1 mm or more, from the perspective of strength and heat dissipation.

With the second three-dimensionally shaped thermally conductive molded body of the present disclosure, the contact surface area when the molded body is applied to an adherand and compressed 50% is increased by approximately 40% or higher, approximately 45% or higher, or approximately 50% or higher, as compared to the contact surface area when this molded body is applied to the adherand without compressing. A molded body demonstrating this performance will have excellent stress relaxation toward the adherend, and a uniform contact surface with fewer voids can more easily be formed on the adherend application surface after compression.

The stress relaxation of the second three-dimensionally shaped thermally conductive molded body can be better demonstrated as the total surface area on the adherent application surface side of the molded body (total surface area of the bottom part outer layer upper surface) increases. The total surface area of the adherend application surface side of the second three-dimensionally shaped thermally conductive molded body can be approximately 50 cm$^2$ or more, approximately 100 cm$^2$ or more, or approximately 200 cm$^2$ or more, from the perspective of stress relaxation.

The thickness of the second three-dimensionally shaped thermally conductive molded body can be approximately 4.0 mm or less, approximately 3.5 mm or less, approximately 3.0 mm or less or approximately 2.5 mm or less, and approximately 0.1 mm or more or approximately 0.55 mm or more.

The compressive stress during approximately 50% compression of the second three-dimensionally shaped thermally conductive molded body can be approximately 10 N/cm$^2$ or less.

The thermal resistance of the second three-dimensionally shaped thermally conductive molded body can be approximately 1.0 K/W or less.

The second three-dimensionally shaped thermally conductive molded body of the present disclosure can be manufactured similar to the aforementioned method, but the method of manufacturing the three-dimensionally shaped thermally conductive molded body is not limited to these. For example, in the following method, a method employing a vacuum heat and compression overlaying device is suggested for overlaying on an extensible film, but the method is not limited to this method, and a vacuum molding method, a film insert molding method, or the like can also be used.

The method of manufacturing the second three-dimensionally shaped thermally conductive molded body can manufacture using the following method, for example.

An extensible film is set on the vacuum heating and compression device 30 instead of the upper part outer layer laminate film 10 illustrated in FIGS. 2A to 2H, and the extensible film is releasably overlaid on the mold that can form the protrusion layer and the gap of the second three-dimensionally shaped thermally conductive molded body by the aforementioned method, to obtain an integrated product including an extensible film and the mold.

A reinforcing substrate such as a nonwoven material or the like is provided on the release film, and a mixture containing a thermally conductive material and a silicone-based material is applied by a knife coater having a predetermined gap interval over the reinforcing substrate to obtain a bottom part outer layer laminate body including the bottom part outer layer.

Next, a mixture containing either the same or different thermally conductive material and silicone-based material as the mixture that was used when producing the bottom part outer layer is filled into the cavity part of the integrated product, a smoothing process is performed using a blade or the like if necessary, the bottom part outer layer covers the mixture filled into the cavity part such that the release film is on the top layer, and the bottom part outer layer laminate body is placed on the mold, and then the silicone-based material is cured.

After optionally cooling the mold, the three-dimensionally shaped thermally conductive molded body with an extensible film can be removed from the mold to obtain a second three-dimensionally shaped thermally conductive molded body. If necessary, the extensible film and/or the release film can be removed, and an appropriate punch out step is performed to obtain a three-dimensionally shaped thermally conductive molded body with a predetermined shape.

The extensible film used in the method of manufacturing a three-dimensionally shaped thermally conductive molded body can be the same as described above.

The three-dimensionally thermally conductive molded body of the present disclosure can be used as a heat dissipating article that can efficiently transfer the heat generated by heat generating components to heat dissipating components by being placed so as to fill a gap between heat dissipating components such as heat sinks or heat pipes and the like and heat generating components such as IC chips or the like that are used in vehicles, lithium ion batteries (for example, automotive lithium ion batteries), home electronics, computer devices, and the like.

The three-dimensionally shaped thermally conductive molded body of the present disclosure can be freely designed for shape and size, and can be used, for example, as a substitute for a potting material in circuit boards, and can also be used for heat generating components with complex shapes such as coils or the like.

EXAMPLES

Specific embodiments of the present disclosure are exemplified in the following examples, but the present invention is not limited to these embodiments. Parts and percents all relate to mass unless otherwise expressly stated.

Raw materials and the like that are used in the present examples are shown in the following Table 2.

| Product name | Explanation | Source |
|---|---|---|
| Emblem (registered trademark) S25 | 25 $\mu$m thick polyester film | Unitika Co., Ltd. (Chuo-ku, Osaka-shi, Japan) |
| Himilan (registered trademark) 1706 | Ionomer resin | Mitsui · Dupont Polychemical Co., Ltd. (Minato-ku, Tokyo, Japan) |
| Dyneon (registered trademark) THV 500 | Thermoplastic fluororesin | 3M Japan Ltd. (Shinagawa-ku, Tokyo, Japan) |
| SE1885 (A/B) | Two component curing type and low temperature curing type silicone gel | Toray · Dow Corning Corporation (Chiyoda-ku, Tokyo, Japan) |
| SE1701LTV | Two component curing type and low temperature curing type silicone adhesive/sealing material | Toray · Dow Corning Corporation (Chiyoda-ku, Tokyo, Japan) |
| CY52-276(A/B) | Two component curing type and low temperature curing type silicone gel | Toray · Dow Corning Corporation (Chiyoda-ku, Tokyo, Japan) |
| CY52-005K | Crosslinking agent for silicone | Toray · Dow Corning Corporation (Chiyoda-ku, Tokyo, Japan) |
| DMS-V22 | Catalyst: Vinyl terminated polydimethylsiloxane polymer | Gelest (USA) |
| AX75-150 | Spherical alumina having an average particle diameter of 75 $\mu$m | Nippon Steel Sumikin Materials Co., Ltd. (Chuo-ku, Tokyo, Japan) |
| AX35-125 | Spherical alumina having an average particle diameter of 3 $\mu$m | Nippon Steel Sumikin Materials Co., Ltd. (Chuo-ku, Tokyo, Japan) |
| AX3-75 | Spherical alumina having an average particle diameter of 4 $\mu$m | Nippon Steel Sumikin Materials Co., Ltd. (Chuo-ku, Tokyo, Japan) |
| Platelets 003 | Hexagonal boron nitride filler | 3M Japan Ltd. (Shinagawa-ku, Tokyo, Japan) |
| SP7297 | Crosslinking agent for silicone | Toray · Dow Corning Corporation (Chiyoda-ku, Tokyo, Japan) |
| YB-2 | 50 $\mu$m thick polyester liner treated on one side with fluoro silicone | Fujimori Industry Co., Ltd. (Shinjuku-ku, Tokyo, Japan) |
| Glass paper GMC 10 - MR 6 | Wet type nonwoven fabric having a basis weight of 9.7 g/m$^2$ manufactured from glass fiber | Oji F-tex Co., Ltd. (Chuo-ku, Tokyo, Japan) |

Characteristics of the first three-dimensionally shaped thermally conductive molded body of the present disclosure were evaluated according to the following method.

[Evaluation Method]

<Asker C hardness evaluation>

The Asker C hardness of the evaluation sample was measured in accordance with SRIS0101 which is the standard of the Japan Rubber Association using an Asker rubber hardness tester C type (manufactured by Kobunshi Keiki Co., Ltd.).

<Evaluation of compressive load>

The compressive load was measured using a Tensilon tester using a jig with a size of 35 mm x 40 mm. The evaluation sample was placed in the Tensilon tester so as to be positioned at the center of the jig, the jig attached to a load meter was moved downward at a speed of 0.5 mm/min, and when the evaluation sample was compressed by 20%, the jig was stopped and the load at that time was measured.

<Thermal conductivity evaluation 1>

The thermal conductivity of large samples (Examples 1 and 2 and Comparative Example 2) were measured using QTM-D3 and a probe (PD-13N) manufactured by Kyoto Electronics Industry Co., Ltd. QTM-D3 measures the thermal conductivity by a method referred to as the nonsteady method fine wire heating method. The probe (sensor) includes a single heating wire stretched linearly and a thermocouple. When a constant current is passed through the heating wire, heat is generated, and the temperature of the heating wire rises exponentially. In samples with high thermal conductivity (such as metals), the heat rapidly moves and escapes to the sample side, so the temperature of the heating wire decreases. On the contrary, in a sample (such as a heat insulating material) having a low thermal conductivity, the heat hardly escapes, so the temperature of the heating wire largely increases. As described above, the temperature rise of the heating wire is related to the thermal conductivity of the sample, and is expressed by the following formula (1). In other words, the thermal conductivity of the sample can be obtained from the slope of the temperature rise graph with the time axis on a logarithmic scale.
[Equation 6]

$$\lambda = q \times \ln(t_2/t_1)/\{4\pi \times (T_2-T_1)\} \quad (1)$$

(in the formula, $\lambda$ is the thermal conductivity of the sample (W/mK), q is the unit time of the heating wire and the heating value in unit length (W/m), t1 and t2 are the measurement time in seconds, and T1 and T2 are temperatures (K) at times t1 and t2.)

Thermal Conductivity Evaluation 2

The thermal conductivity of small samples (Examples 3 to 8 and Comparative Example 3) were measured in accordance with Measurement Method for Thermal Resistance/Thermal Conductivity ASTM D5470 using a thermal resistance measuring device (TIM Tester 1400 manufactured by Analysis Tech, Inc.). Two aluminum blocks (aluminum plates) were installed between the heater of the thermal resistance measuring device and the cooling plate. A sample was inserted between the aluminum blocks, and a predetermined load (compression rate) was applied, and the thermal conductivity was measured. Note that when measuring, the compression ratio was adjusted so that the sample was in contact with substantially the same areas in the heater and the cooling plates. The compression ratio was approximately 30% in all of the samples.

Evaluation of Assemblability

Assemblability of the evaluation sample was evaluated. Samples where peeling from the liner and sample handling was easy (no noticeable elongation) were evaluated as "good", samples where peeling from the liner was possible but plastic deformation occurred and handling was difficult were evaluated as "acceptable", and samples where peeling from the liner was not possible were evaluated as "unacceptable".

Evaluation of Reworkability

For the small samples (Examples 3 to 8), reworkability was evaluated by the following method. Note that the sheet-like samples of comparative examples 2 and 3 were similarly evaluated for punching out a cylindrical shape with a diameter of 16.5 mm. Two float glass plates of 5 cm $\times$ 10 cm were prepared. Five samples were placed on the surface of one sheet of glass so that the bottom part was in contact at even intervals. Another glass plate was placed thereon, and a weight of 1 kg was placed thereon such that a load was equally applied to each sample. These glass plates were allowed to stand in an oven with a temperature adjusted to 150°C for 24 hours under load. Thereafter, the sample was removed from the oven and cooled, and the upper glass plate was peeled off while returning to room temperature. Of the five samples, those samples where the sample shape did not change, peeling from the bottom glass plate did not occur, and all of the sample remained were evaluated as "good", samples where the sample shape did not change and one or more samples adhered to the upper glass plate were evaluated as "acceptable", and samples where there was peeling from the glass plate and samples with shape deformation when the glass plate was peeled were evaluated as "unacceptable".

Example 1

Himilan (registered trademark) 1706 which is an ionomer resin was melted with a single screw extruder having a diameter of 20 mm set at a barrel temperature of 200° C. The molten resin was supplied to a die set at 220° C with a screw rotating at 59 rpm, and the molten resin discharged from the die was transferred onto a PET film (Emblem (registered trademark) S25) having a thickness of 25 $\mu$m at a conveying speed of 1.8 m/minute, and an ionomer resin/PET laminated film having a thickness of 125 $\mu$m was prepared.

500 g of CY-52-276A and 250 g of Platelets 003 were weighed in a 2 L volume planetary mixer and mixed for 15 minutes at an rpm of 20 rpm to produce a silicone compound 1A. Similarly, 500 g of CY-52-276B, 5.0 g of CY52-005K, and 250 g of Platelets 003 were weighed in a planetary mixer and mixed for 15 minutes at a blade speed of 20 rpm to prepare a silicone compound 1B. 200 g of silicone compound 1A and 200 g of silicone compound 1B were weighed into a polycup and mixed with a resin spatula with stirring for approximately 10 minutes to prepare a silicone compound 1AB. The silicone compound 1AB was coated on the ionomer resin side of the ionomer resin/PET laminated film with a knife coater. The coated ionomer resin/PET laminated film was passed through an oven at 120° C for 18 minutes to cure the silicone to prepare a boron nitride-containing silicone rubber sheet 1 for the upper part outer layer. The thickness of the silicone rubber layer of the sheet 1 was 213 $\mu$m.

121.4 g of AX 35-125, 48.6 g of AX 3-75, and 30.0 g of SE1885A were weighed into a 225 mL glass bottle. The material in the glass bottle was rotated by using a revolution mixer "Awatori Rentaro" at a rotational speed of 2000 rpm for 1 minute, and then degassed for 30 seconds to prepare a silicone compound 2A. Similarly, 121.4 g of AX35-125, 48.6 g of AX3-75, and 30.0 g of SE1885B were weighed into a 225 mL glass bottle. The material in the glass bottle was rotated using a revolution mixer "Awatori Rentaro" at a rotational speed of 2000 rpm for 1 minute, and then degassed for 30 seconds to prepare a silicone compound 2B. 150 g of silicone compound 2A and 100 g of silicone compound 2B were weighed into a 300 mL polycup and mixed with a resin spatula with stirring for approximately 5 minutes to prepare a silicone compound 2AB for the middle member.

140.0 g of SE1701LTV and 14.0 g of SE1701LTV catalyst were weighed into a 300 mL polycup and mixed with a resin spatula with stirring for approximately 5 minutes such that bubbles were not introduced, to prepare a silicone compound 3. Next, the silicone compound 3 was applied onto YB-2 which is a release liner, and was coated with a knife coater where a gap between the knife and the liner was set to 150 $\mu$m to produce the bottom part outer layer sheet 1.

The PET film of the boron nitride-containing silicone rubber sheet 1 was removed to produce a two-layered upper part outer layer laminated film 10 made of an ionomer resin/boron nitride-containing silicone rubber that can be deep drawn. A double-sided vacuum molding machine (manufactured by Fuse Vacuum Forming) was adopted as a vacuum heating and compression bonding device 30 as shown in FIG. 2B, and an ionomer resin was placed on an aluminum mold 20 set in the device 30 and the upper part outer layer laminated film 10 was fixed so as to be on the mold 20 side. Heating conditions were set such that the surface temperature of the film 10 was 120° C. Next, a heated film 10 was laminated onto the surface of the mold 20 such that air was not incorporated in accordance with the procedures shown in the aforementioned FIG. 2B to FIG. 2E to produce an integrated product 40 as illustrated in FIG. 2F. Herein, the mold 20 has a shape as shown in FIG. 2F so as to obtain a substantially domed prism three-dimensional shape with a size of 23.5 mm × 90.0 mm × 4.0 mm.

The hollow portion 11 of the integrated product 40 was filled with the silicone compound 2AB for the middle member, and then the bottom part outer layer sheet 1 was laminated on the filled silicone compound 2AB such that no air was incorporated. A rubber roller was applied onto the sheet 1 such that the sheet 1 adhered uniformly to the mold to produce a final integrated product 50. The final integrated product 50 was allowed to stand in an oven at 120° C for 2 minutes to thermally cure the silicone gel constituting the middle member and the bottom part outer layer. Next, the final integrated product 50 was removed from the oven and cooled, and the cured substantially domed prism shaped three-dimensionally shaped thermally conductive molded body 60 was removed from the mold 20. Prior to cooling and hardening, the ionomer resin layer of the outermost layer was removed to obtain an evaluation sample with a substantially domed prism three-dimensionally shaped thermally conductive molded body. Note that the test piece prepared by injecting the silicone compound 2AB for the middle member into a 30 mm × 40 mm × 10 mm thick mold coated with YB-2 release liner in an oven at 120° C had an Asker C hardness of 0.

Example 2

75.0 g of AX3-75 and 25.0 g of CY52-276A were weighed into a 225 mL glass bottle. The material in the glass bottle was rotated using a revolution mixer "Awatori Rentaro" at a rotational speed of 2000 rpm for 1 minute, and then degassed for 30 seconds to prepare a silicone compound 4A. Similarly, 75.0 g of AX3-75, 25.0 g of CY52-276B and 0.25 g of CY52-005K were weighed into a 225 mL glass bottle. The material in the glass bottle was rotated using a revolution mixer "Awatori Rentaro" at a rotational speed of 2000 rpm for 1 minute, and then degassed for 30 seconds to prepare a silicone compound 4B. 80 g of silicone compound 4A and 80 g of silicone compound 4B were weighed into a 300 mL polycup and mixed with a resin spatula with stirring for approximately 5 minutes to prepare a silicone compound 4AB. Glass paper GMC10-MR6 was placed on YB-2 which is a release liner, and then the silicone compound 4AB was applied onto the glass paper, and the bottom part outer layer sheet 2 was produced by coating and permeating using a knife coater with a gap between the knife and the liner set to 150 $\mu$m. Evaluation samples of a substantially domed prism shaped three-dimensionally shaped thermally conductive molded body were obtained using the same method as Example 1, except that the bottom part outer layer sheet 2 was used instead of the bottom part outer layer sheet 1. Therefore, similar to Example 1, the Asker C hardness of the fabricated test piece was 0.

Example 3

150.0 g of silicone compound 2A and 122.7 g of silicone compound 2B were weighed into a 300 mL polycup, and the content was mixed with a resin spatula for approximately 5 minutes such that bubbles were not incorporated to prepare a silicone compound 5AB. An evaluation sample of a substantially dome shaped three-dimensionally shaped thermally conductive molded body was fabricated by the same method as example 1, except that a silicone compound 5AB was used in place of the silicone compound 2AB, and a mold was used having a configuration where a plurality of rows of three-dimensional shapes with a substantially domed shape having a diameter of 19 mm and a thickness of 4.0 mm were arranged in parallel so as to not overlap in the longitudinal direction and the lateral direction. Note that the test piece prepared by injecting the silicone compound 5AB for the middle member into a 30 mm $\times$ 40 mm $\times$ 10 mm thick mold coated with YB-2 release liner and cured in an oven at 120° C had an Asker C hardness of 0.

Example 4

A bottom part outer layer sheet 3 was fabricated by the same method as Example 2, except that a silicone compound 3 was used in place of the silicone compound 4AB. An evaluation sample of a substantially dome shaped three-dimensionally shaped thermally conductive molded body was fabricated by the same method as example 1, except that a silicone compound 5AB was used in place of the silicone compound 2AB, the mold was changed to the mold used in Example 3, and the bottom part outer layer sheet 3 was used in place of the bottom part outer layer sheet 3. Therefore, similar to Example 3, the Asker C hardness of the fabricated test piece was 0.

Example 5

Dyneon (registered trademark) THV500 which is a fluorine resin was melted with a single screw extruder having a diameter of 20 mm set at a barrel temperature of 200° C - 220°C - 230°C - 260°C. The molten resin was supplied to a die set at 260° C, the molten resin was discharged from the die and extrusion laminated onto a PET film with a thickness of 75 $\mu$m to produce a fluorine resin/PET laminate film. The thickness of the fluorine resin layer was 100 $\mu$m.

Next, 100 g of silicone compound 2A and 100.0 g of silicone compound 2B were weighed into a 300 mL polycup, and the content was mixed with a resin spatula for approximately 5 minutes such that bubbles were not incorporated to prepare a silicone compound 5AB.

Silicon compound 6AB was placed on YB-2 which is a release liner, and then the silicone compound 4AB was applied onto the glass paper GMC-10-MR, and the bottom part outer layer sheet 4 was produced by coating and permeating using a knife coater with a gap between the knife and the liner set to 150 $\mu$m.

A fluorine resin film that can be deep draw molded was produced by removing the PET film of the laminate film. A vacuum heating and compression bonding device similar to Example 1 was used, and the mold had a plurality of substantially dome-shaped three-dimensional shapes having a diameter of 16.5 mm and a thickness of 2.6 mm arranged in parallel in the longitudinal direction and the lateral direction, alternatingly shifted. The mold was used after spraying spray glue 55 (produced by 3M Japan) and then drying. Applying the fluorine resin film to the mold was performed in a manner similar to Example 1.

Silicone compound 6AB was injected onto the mold coated with a fluorine resin film, and then the bottom part outer layer sheet 4 was laminated on the application surface of the silicone compound such that no air was incorporated. The mold covered with the bottom part outer layer sheet 4 was compression bonded using a rubber roller such that the sheet was bonded uniformly to the mold to produce the final integrated product. The final integrated product was allowed to stand in an oven at 120° C for 20 minutes to thermally cure the silicone gel constituting the molded body. Next, the final integrated product was removed from the oven and naturally cooled to room temperature, and after sitting for one day, the cured three-dimensionally shaped thermally conductive molded body was removed from the mold. Next, an evaluation sample of a three-dimensionally shaped thermally conductive molded body with a substantially domed shape having a diameter of 16.5 mm and a thickness of 2.6 mm was prepared by removing the fluorine resin film on the surface. Note that a test piece prepared by injecting the silicone compound 6AB into a 30 mm $\times$ 40 mm $\times$ 10 mm thick mold coated with YB-2 release liner and cured in an oven at 120° C had an Asker C hardness of 0.

Example 6

121.4 g of AX35-125, 48.6 g of AX3-75, and 30.0 g of SE1885A were weighed into a 225 mL glass bottle. The contents of the glass bottle were mixed using a revolution mixer "Awatori Rentaro" at a rotational speed of 2000 rpm for 1 minute, and then degassed for 30 seconds to prepare a silicone compound 7A. Silicone compound 7B was prepared by similarly weighing 121.4 g of AX35-125, 48.6 g of AX 3-75, 30.0 g of SE1885B, and 0.0375 g of additive "SP7297" into a 225 mL glass bottle, mixing for 1 minute at a speed of 2000 rpm using an AWATORI RENTARO, and then degassing for 30 seconds. 100 g of silicone compound 7A and 100 g of silicone compound 7B were weighed into a 300 mL polycup, and the contents were mixed with a resin spatula for approximately 5 minutes such that bubbles were not incorporated to prepare a silicone compound 7AB. A bottom part outer layer sheet 5 was fabricated by the same method as Example 5, except that silicone compound 7AB, fluorosilicone liner YB-2, and glass paper GMC10-MR6 were used. An evaluation sample of a substantially dome shaped three-dimensionally shaped thermally conductive molded body with a diameter of 16.5 mm and a thickness of 2.6 mm was prepared by the same method as example 5, except that a silicone compound 7AB was used in place of the silicone compound 6AB. Note that the test piece prepared by injecting the silicone compound 7AB into a 30 mm × 40 mm × 10 mm thick mold coated with YB-2 release liner on the inside and cured in an oven at 120° C had an Asker C hardness of 5.

Example 7

121.4 g of AX35-125, 48.6 g of AX3-75, and 30.0 g of SE1885A were weighed into a 225 mL glass bottle. The contents of the glass bottle were mixed using a revolution mixer "Awatori Rentaro" at a rotational speed of 2000 rpm for 1 minute, and degassed for 30 seconds to prepare a silicone compound 8A. Silicone compound 8B was prepared by similarly weighing 121.4 g of AX35-125, 48.6 g of AX 3-75, 30.0 g of SE1885B, and 0.075 g of additive "SP7297", mixing for 1 minute at a speed of 2000 rpm using an AWATORI RENTARO, and then degassing for 30 seconds. 100 g of silicone compound 8A and 100 g of silicone compound 8B were weighed into a 300 mL polycup, and the content was mixed with a resin spatula for approximately 5 minutes such that bubbles were not incorporated to prepare a silicone compound 8AB. A bottom part outer layer sheet 6 was fabricated by the same method as Example 5, except that silicone compound 8AB, fluorosilicone liner YB-2, and glass paper GMC10-MR6 were used. An evaluation sample of a substantially dome shaped three-dimensionally shaped thermally conductive molded body with a diameter of 16.5 mm and a thickness of 2.6 mm was prepared by the same method as example 5, except that a silicone compound 8AB was used in place of the silicone compound 6AB. Note that the test piece prepared by injecting the silicone compound 8AB into a 30 mm × 40 mm × 10 mm thick mold coated with YB-2 release liner on the inside and cured in an oven at 120° C had an Asker C hardness of 8.

Example 8

121.4 g of AX35-125, 48.6 g of AX3-75, and 30.0 g of SE1885A were weighed into a 225 mL glass bottle. Next, the contents of the glass bottle were mixed using a revolution mixer "Awatori Rentaro" at a rotational speed of 2000 rpm for 1 minute, and then degassed for 30 seconds to prepare a silicone compound 9A. Similarly, 121.4 g of AX35-125, 48.6 g of AX3-75, 30.0 g of SE1885B, 0.150 g of SP7297 were weighed into a 225 mL glass bottle.
The contents of the glass bottle were mixed using a revolution mixer "Awatori Rentaro" at a rotational speed of 2000 rpm for 1 minute, and then degassed for 30 seconds to prepare a silicone compound 9B. 100 g of silicone compound 9A and 100 g of silicone compound 9B were weighed into a 300 mL polycup, and the contents were mixed with a resin spatula for approximately 5 minutes such that bubbles were not incorporated to prepare a silicone compound 9AB. A bottom part outer layer sheet 7 was fabricated by the same method as Example 5, except that silicone compound 9AB, fluorosilicone liner YB-2, and glass paper GMC10-MR6 were used. An evaluation sample of a substantially dome shaped three-dimensionally shaped thermally conductive molded body with a diameter of 16.5 mm and a thickness of 2.6 mm was prepared by the same method as example 5, except that a silicone compound 9AB was used in place of the silicone compound 6AB. Note that the test piece prepared by injecting the silicone compound 9AB into a 30 mm × 40 mm × 10 mm thick mold coated with YB-2 release liner and cured in an oven at 120° C had an Asker C hardness of 30.

Comparative Example 1

A silicone gel sheet having a thickness of 2 mm was obtained by applying a silicone compound 2AB between two release liners (YB-2) and passing through a knife coater head with a gap between the liners set to 2 mm. Next, the sheet was allowed to stand in an oven at 120° C for 20 minutes to cure the silicone gel sheet. The cohesive force of the sheet was extremely low so the sheet could not be removed from the release liner, and the various properties of the sheet could not be measured.

Comparative Example 2

A silicone gel sheet having a thickness of 2 mm was obtained by applying a silicone compound 6AB between two release liners (YB-2) and passing through a knife coater head with a gap between the liners set to 2 mm. Next, the sheet was allowed to stand in an oven at 120° C for 20 minutes to cure the silicone gel sheet. Two sheets were prepared by peeling one sheet of the two liner sheets, the two sheets were overlaid such that gas bubbles were not incorporated between the layers to obtain a silicone thermally conductive sheet for evaluation with a thickness of 4 mm. Note that the Asker C hardness of a test piece produced by overlaying three sheets with a thickness of 4 mm was 0.

Comparative Example 3

A silicone gel sheet having a thickness of 2.6 mm was obtained by applying a silicone compound 9AB between two release liners (YB-2) and passing through a knife coater head with a gap between the liners set to 2.6 mm. Next, the sheet was allowed to stand in an oven at 120° C for 20 minutes to cure the silicone gel sheet and produce a silicone thermally conductive sheet for evaluation with a thickness of 2.6 mm. Note that the Asker C hardness of a test piece produced by overlaying three sheets with a thickness of 2.6 mm was 30. The compressive stress was measured using a sample punched from this sheet in the cylindrical shape with a diameter of 16.5 mm.

Table 3 shows the results of Asker C hardness, compressive load (load at 20% compression), thermal conductivity 1 and 2, assemblability and reworkability for Examples 1 to 8 and Comparative Examples 1 to 3.

[Table 3]

| | Thickness (mm) | Layer configuration | Asker C hardness | Load at 20% compression (N) | Thermal conductivity 1 (W/mK) | Thermal conductivity 2 (W/mK) | Assemblability | Reworkability |
|---|---|---|---|---|---|---|---|---|
| Example 1 | 4.0 | 3 layers | 0 | 0.60 | 1.32 | - | Good | - |
| Example 2 | 4.0 | 3 layers | 0 | 0.48 | 1.39 | - | Good | - |
| Example 3 | 4.0 | 3 layers | 0 | 1.14 | - | 1.05 | Good | Good |
| Example 4 | 4.0 | 3 layers | 0 | 1.48 | - | 1.07 | Good | Good |
| Example 5 | 2.6 | 1 layer | 0 | 1.23 | - | 1.78 | Good | Good |
| Example 6 | 2.6 | 1 layer | 5 | 3.26 | - | 1.85 | Good | Good |
| Example 7 | 2.6 | 1 layer | 8 | 3.04 | - | 1.68 | Good | Good |
| Example 8 | 2.6 | 1 layer | 30 | 8.94 | - | 1.62 | Good | Good |
| Comparative Example 1 | - | 1 layer | - | - | - | - | Unacceptable | - |
| Comparative Example 2 | 4.0 | 1 layer | 0 | 1.19 | 1.42 | - | Acceptable | Unacceptable |
| Comparative Example 3 | 2.6 | 1 layer | 30 | 11.41 | - | 1.62 | Good | Acceptable |

As shown in Table 3, the three-dimensionally shaped thermally conductive molded body of the present disclosure demonstrates excellent flexibility and compressive stress. In addition, when comparing Example 8 and Comparative Example 3, even though the same silicone compound 9AB was used and the same Asker C hardness was demonstrated, the stress at 20% compression of Example 8 was approximately 78% compared with the stress of Comparative Example 3, and therefore Example 8 demonstrated stress that was lower than Comparative Example 3. These results suggest that the shape of the molded body reduced the stress at 20% compression, or in other words the stress applied to the various members where the molded body was applied could be reduced.

Characteristics of the second three-dimensionally shaped thermally conductive molded body of the present disclosure were evaluated according to the following method.

[Evaluation Method]

Asker C hardness evaluation

The Asker C hardness of the evaluation sample was measured in accordance with SRIS0101, which is a standard of the Japan Rubber Association, using an Asker rubber hardness tester C type (manufactured by Kobunshi Keiki Co., Ltd.).

Evaluation of compressive stress

The compressive load was measured using a Tensilon tester using a plate jig. The 330 mm x 88 mm evaluation sample was placed in the Tensilon tester so as to be positioned at the center of the jig in order to compress, the jig attached to a load meter was moved downward at a speed of 5.0 mm/min, and when the evaluation sample was compressed by 1.0 mm, the jig was stopped and the load at that time was measured.

Evaluation of thermal resistance

The thermal resistance value of the evaluation sample was measured with a thermal impedance meter TIM tester manufactured by Analysis Tech. The measurement principles of this device are described below.

The TIM Tester can measure the thermal resistance value in accordance with ASTM D5470. The probe (sensor) includes a heater plate, cooling plate, and a plurality of thermocouples. A sample of a 33.0 mm diameter cylindrical TIM is compressed 1.0 mm by a heater and a cooling plate. When the test is started, constant heat is added by the heat rays of the heater plate. Herein, the cooler is cooled by normal water. After the temperature stabilizes, the heat flow rate and temperature at the sample interface are calculated by the temperature data obtained from the plurality of thermocouples (FIG. 12). The thermal resistance value is calculated from these results and the following formula (2) based on the heat flux and the temperature difference between the contact points of the heater and the cooler.

[Equation 7]

$$\text{Thermal resistance value (K/W)} = \text{temperature difference (K)} / \text{heat flux (W) (2)}$$

Evaluation of tensile adhesive strength (reworkability)

The bottom part outer layer surface was backed with single-sided pressure sensitive adhesive tape (product number #851A manufactured by Sumitomo 3M Limited), the protruding layer surface of the evaluation sample was attached to a glass plate, pressure was applied and the protruding layer was deformed until there was no gap, and then the 90° peel adhesive strength was measured in accordance with the procedures set forth in JIS Z 0237. Peeling of the molded body was performed at a tensile speed of 300 mm/minute.

Example 9

Himilan (registered trademark) 1706 which is an ionomer resin was melted with a single screw extruder having a diameter of 20 mm set at a barrel temperature of 200° C. The molten resin was supplied to a drop die set at 220 °C with a screw rotating at 59 rpm, and the molten resin discharged from the drop die was cast onto a PET film (Emblem (registered trademark) S25) having a thickness of 25 μm at a conveying speed of 1.8 m/minute, and an ionomer resin/PET laminated film having a thickness of 125 μm was produced.

108 g of AX75-150, 36 g of AX35-125, 36 g of AX3-75, 1 g of DMS-V22 and 19 g of SE1885A were weighed into a 225 mL glass bottle. The material in the glass bottle was rotated by using a revolution mixer "Awatori Rentaro" at a rotational speed of 2000 rpm for 1 minute, and then degassed for 30 seconds to prepare a silicone compound 1a. Similarly, 108 g of AX75-150, 36 g of AX35-125, 36 g of AX3-75, 1 g of DMS-V 22 and 19 g of SE1885B were weighed into a 225 mL glass bottle and similarly mixed and degassed to prepare a silicone compound 1b. 150 g of silicone compound 1a and 150 g of silicone compound 1b were weighed into a polycup and mixed with a resin spatula for approximately 10 minutes to prepare a silicone compound 1ab.

The PET film was removed from the above ionomer resin/PET laminated film to obtain an ionomer resin film capable of deep drawing. A double-sided vacuum molding machine (manufactured by Fuse Vacuum Forming) was adopted as a vacuum heating and compression bonding device as shown in FIG. 2B, and an ionomer resin was placed on an aluminum mold set in the device. Heating conditions were set such that the surface temperature of the film was 120° C. Next, a heated film was laminated onto the surface of the mold such that air was not incorporated in accordance with the procedures shown in the aforementioned FIG. 2B to FIG. 2E to produce an integrated product as illustrated in FIG. 2F.

After arranging glass paper GMC10-MR 6 as a reinforcing substrate on YB-2 which is a release film, the silicone gel compound 1ab was coated onto the glass paper with a knife coater having a gap of 150 $\mu$m, thereby obtaining a bottom part outer layer laminated sheet having a bottom part outer layer.

The hollow portion of the integrated product covered by the ionomer resin film was filled with the silicone gel compound 1ab, and then the bottom part outer layer sheet was laminated on the filled silicone compound 1ab such that no air was incorporated. A rubber roller was applied onto the sheet such that the sheet adhered uniformly to the mold to produce a final integrated product. The final integrated product was allowed to stand in an oven at 120°C for 10 minutes to thermally cure the silicone gel. Next, the final integrated product was removed from the oven and allowed to cool, and the cured three-dimensionally shaped thermally conductive molded body was removed from the mold such that the ionomer resin film was removed from the mold. Next, prior to cooling and hardening, the ionomer resin film was removed from the three-dimensionally shaped thermally conductive molded body to obtain an evaluation sample of a three-dimensionally shaped thermally conductive molded body. Herein, the mold that was used had a shape that can provide a protruding layer with a substantially hexagonal upper part flat surface as illustrated in FIG.11, and the evaluation sample of the three-dimensionally shaped thermally conductive molded body obtained from this mold had a gap width (A), protrusion layer height (B), protrusion layer bottom surface circumscribed circle diameter (C), taper angle, and number of protrusions per square inch as illustrated in Table 4.

Examples 10 to 11

Evaluation samples for example 10 and example 11 were obtained by the same method as example 9, except for changing to a mold that can provide a three-dimensionally shaped thermally conductive molded body that satisfies the interval width (A), protrusion layer height (B), protrusion layer bottom surface circumscribed circle diameter (C), taper angle, and number of protrusions per square inch as shown in Table 4.

Comparative Example 4

A silicone gel sheet having a thickness of 1.5 mm was obtained by applying a silicone compound 1ab between two release liners (YB-2) and passing through a knife coater head with a gap between the liners set to 2.1 mm. Next, the sheet was allowed to stand in an oven at 120° C for 20 minutes to cure the silicone gel sheet, and then 4 sheets were laminated to make an evaluation sample with a thickness of 6.0 mm.

Comparative Example 5

A silicone gel sheet having a thickness of 1.5 mm was obtained by applying a silicone compound 1ab between two release liners (YB-2) and passing through a knife coater head with a gap between the liners set to 2.1 mm. Next, the sheet was allowed to stand in an oven at 120° C for 20 minutes to cure the silicone gel sheet, and then 3 sheets were laminated to make an evaluation sample with a thickness of 4.5 mm.

Comparative Example 6

A silicone gel sheet having a thickness of 1.5 mm was obtained by applying a silicone compound 2ab between two release liners (YB-2) and passing through a knife coater head with a gap between the liners set to 2.1 mm. Next, the sheet was allowed to stand in an oven at 120° C for 20 minutes to cure the silicone gel sheet, and then 2 sheets were laminated to make an evaluation sample with a thickness of 3 mm.

The results for the Asker hardness, compressive stress (stress when compressed 1 mm), thermal resistance (thermal resistance when compressed 1 mm), and tensile strength are shown in Table 4 for Examples 9 to 11 and Comparative examples 4 to 6.

| | Gap width A (mm) | Height B (mm) | Diameter of circumscribed circle C (mm) | Thickness of molded body D (mm) | Taper angle (degree) | α | X[1] (%) | Y[2] (%) | Number per square inch | Asker C hardness | Compression stress (N/cm$^2$) | Thermal resistance (K/W) | Tensile adhesive strength (N/cm$^2$) |
|---|---|---|---|---|---|---|---|---|---|---|---|---|---|
| Example 9 | 1.1 | 2.6 | 6.5 | 3.0 | 85 | 0.88 | 38.5 | 69.9 | 14 | 10 | 0.5 | 0.93 | 8 |
| Example 10 | 1.6 | 2.1 | 5.9 | 2.5 | 85 | 0.90 | 47.6 | 58.2 | 14 | 10 | 2.9 | 0.87 | 8 |
| Example 11 | 1.9 | 1.0 | 3.8 | 2.0 | 85 | 0.94 | 62.5 | 39.9 | 22 | 10 | 4.1 | 0.56 | 8 |
| Comparative Example 4 | - | - | - | 6.0 | - | - | - | | - | 10 | 4.4 | 2.22 | 3 |
| Comparative Example 5 | - | - | | 4.5 | - | - | - | - | - | 10 | 14.6 | 1.37 | 5 |
| Comparative Example 6 | - | - | - | 3.0 | - | - | - | - | - | 10 | > 17.6 (Not measurable) | 0.77 | 15 |

1) Compression ratio when the interval is completely filled by the compression deformation of the protruding layer (%)
2) Ratio (%) of the total area of the bottom surface of the protrusion layer to the total surface area of the upper surface of the bottom part outer layer.

With a conventional flat heat releasing sheet similar to Comparative Examples 4 to 6, as the thickness of the molded body becomes thinner, the thermal resistance has a tendency to drop, but the compression stress and the tensile adhesive strength will conversely have a tendency to increase. As a result, if there is an attempt to obtain a molded body with low thermal resistance using a conventional flat heat dissipating sheet the compression stress and the tensile adhesive strength will increase, so the heat dissipating sheet will cause damage to the molded body or have inferior reworkability, or the like. On the other hand, in the case of the second three-dimensionally shaped thermally conductive molded body of the present disclosure, as can be seen from Examples 9 to 11, even if the thickness of the molded body is the same or less than the thickness of the sample of Comparative Example 6, it was confirmed that the compressive stress and tensile bond strength can be kept low, in addition to the thermal resistance. Therefore, the second three-dimensionally shaped thermally conductive molded body of the present disclosure can provide favorable thermal conductivity, and can reduce problems with the adherend as compared to a conventional flat heat dissipating sheet.

[Reference Numerals]

1, 60 First three-dimensionally shaped thermally conductive molded body
2, 13, 110 Bottom part outer layer
3, 12 Middle member
4 Upper part outer layer
10 Upper part outer layer laminate film
20 Mold
30 Vacuum heat and compression bonding device
31 First vacuum chamber
32 Second vacuum chamber
33 Pedestal
34 Partition plate
35 Raising and lowering table
40 Integrated product
50 Final integrated product
100 Second three-dimensionally shaped thermally conductive molded body
102 Release film
104, 108 Silicone-based material
106 Reinforcing base
112 Protruding layer
114 Gap
a First height
b Second height
A Width of gap
B Height of protruding layer
C Diameter of circumscribed circle of bottom surface of protrusion layer
D Thickness of second three-dimensionally shaped thermally conductive molded body
θ Taper angle

## Claims

1. A three-dimensionally shaped thermally conductive molded body comprising a thermally conductive material and a silicone-based material, wherein
the molded body has a substantially flat bottom surface, and a three-dimensional shaped part located on the inside of the bottom surface, and the height of the three-dimensionally shaped part that is higher than the bottom surface differs in at least two locations.

2. The three-dimensionally shaped thermally conductive molded body according to claim 1, wherein at least a portion of the three-dimensionally shaped part is covered by an upper part outer layer containing a silicone-based material.

3. The three-dimensionally shaped thermally conductive molded body according to claim 1 or 2, wherein a nonwoven material is internally provided on a side of the bottom surface.

4. The three-dimensionally shaped thermally conductive molded body according to any one of claims 1 to 3, wherein at least a portion of the three-dimensionally shaped part has a substantially dome shape or a substantially domed prism shape.

5. The three-dimensionally shaped thermally conductive molded body according to any one of claims 1 to 3, wherein the shape of the three-dimensionally shaped part substantially matches the shape of an adherend member to which the shaped part is applied.

6. The three-dimensionally shaped thermally conductive molded body according to any one of claims 1 to 5, wherein the molded body includes a bottom part outer layer with the aforementioned bottom surface, an upper part outer layer provided so as to cover the bottom part outer layer, and a middle member provided between the bottom part outer layer and the upper part outer layer, with the upper part outer layer, middle member, and bottom part outer layer containing a silicone-based material.

7. The three-dimensionally shaped thermally conductive molded body according to claim 6, wherein the upper part outer layer and the bottom part outer layer, or the bottom part outer layer and the middle member are integrated and made of the same material.

8. The three-dimensionally shaped thermally conductive molded body according to claim 6 or 7, wherein the upper part outer layer contains silicone rubber, the middle member contains silicone gel, and the bottom part outer layer contains silicone rubber or silicone gel.

9. The three-dimensionally shaped thermally conductive molded body according to any one of claims 6 to 8, wherein the middle member is more flexible than the upper part outer layer and/or the bottom part outer layer.

10. The three-dimensionally shaped thermally conductive molded body according to any one of claims 1 to 9, wherein the tackiness differs between the bottom surface and a surface portion of the three-dimensionally shaped thermally conductive molded body excluding the bottom surface.

11. A method of manufacturing a three-dimensionally shaped thermally conductive molded body, comprising:

preparing a mixture containing a thermally conductive material and a silicone-based material;
preparing a mold that can provide a molded body with a substantially flat bottom surface, and a three-dimensional shaped part located on the inside of the bottom surface, and the height of the three-dimensionally shaped part that is higher than the bottom surface differs in at least two locations;
providing an extensible film on the mold so as to enable contact with the mold inner surface;
overlaying the extensible film on the mold;
filling the aforementioned mixture into a hollow part of the mold on which the extensible film has been overlaid, and performing a smoothing process of an optional portion that forms the bottom surface of the molded body;
curing the mixture in the mold; and
providing the three-dimensionally shaped thermally conductive molded body by removing the three-dimensionally shaped thermally conductive molded body with an extensible film, after optionally cooling the mold, and optionally punching out a portion that does not have the mold shape.

12. A method of manufacturing a three-dimensionally shaped thermally conductive molded body, comprising:

forming the upper part outer layer by applying and curing a first silicone-based material containing a thermally conductive material on the extensible film of a laminate film containing an extensible film and a release film;
removing the release film of a laminate film having the upper part outer layer, and then placing the laminate film on the mold such that the extensible film can contact the inner surface of the mold, where the mold is a mold that can provide a molded body with a substantially flat bottom surface and a three-dimensional shaped part located on the inside of the bottom surface, and the height of the three-dimensionally shaped part that is higher than the bottom surface differs in at least two locations;
overlaying the laminate film on the mold;
filling the middle member containing a second silicone-based material including a thermally conductive material into a hollow part of the mold on which the extensible film was overlaid, and optionally performing a smoothing process of a portion positioned on the bottom surface side of the molded body;
forming the bottom part outer layer by applying a third silicone-based material containing a thermally conductive material onto the release film and placing the release film containing the bottom part outer layer on the mold such that the release film is an outermost layer, such that the bottom part outer layer covers the upper part outer layer and the middle member filled in the hollow part;

curing the second silicone-based material that forms the middle member and the third silicone-based material including the bottom part outer layer if present;

providing the three-dimensionally shaped thermally conductive molded body by optionally cooling the mold, removing the three-dimensionally shaped thermally conductive molded body with an extensible film and a release film if present from the mold, optionally removing the extensible film and/or the optional release film if present, and optionally punching out the upper part outer layer portion that does not include the middle member and the bottom part outer layer portion if present.

13. A three-dimensionally shaped thermally conductive molded body having a plurality of protruding layers and a bottom part outer layer, wherein

the protruding layer includes a thermally conductive material and a silicone-based material;

the bottom part outer layer includes a thermally conductive material, a silicone-based material, and a reinforcing base;

the protruding layers arranged to provide a gap between adjacent protruding layers such that the bottom surface outer circumferential parts of adjacent protruding layers do not contact; and

the following Equation (I) is satisfied

[Equation 1]

$$\alpha Y = 100 - X \ (I)$$

[in the equation, $\alpha$ is 0.70 to 1.00, X is the compression ratio (%) when the gap is completely filled by compression deforming of the protruding layer, and Y is the ratio (%) of the total area of the bottom part outer layer upper surface occupied by the total surface area of the protruding layer bottom surface.]

14. The three-dimensionally shaped thermally conductive molded body according to claim 13, wherein the width of the gap is substantially uniform.

15. The three-dimensionally shaped thermally conductive molded body according to claim 13 or 14, wherein the upper surface of the protruding layer is substantially a flat surface.

16. The three-dimensionally shaped thermally conductive molded body according to claim 15, wherein the shape of the substantially flat surface is a substantially equilateral triangle, a substantially square shape, a substantially regular pentagon shape, a substantially regular hexagon shape, a substantially rectangular shape, or a substantially wavy shape, wherein the protruding layer has a cross-sectional part along each leg of the shape, and each adjacent leg of the aforementioned shape of adjacent protruding layers has a substantially flat shape.

17. The three-dimensionally shaped thermally conductive molded body according to claim 13 to 16, wherein the taper angle of the protruding layer is 80 degrees to 90 degrees.

18. The three-dimensionally shaped thermally conductive molded body according to any one of claims 13 to 17, wherein the Asker C hardness of the protruding layer is 0 to 30.

19. The three-dimensionally shaped thermally conductive molded body according to any one of claims 13 to 18, wherein the contact surface area when the three-dimensionally shaped thermally conductive molded body is applied to an adherend and compressed 50% is increased 40% or more as compared to the contact surface area when the three-dimensionally shaped thermally conductive molded body is applied to the adherend without compressing.

20. The three-dimensionally shaped thermally conductive molded body according to any one of claims 13 to 19, having five or more protruding layers per square inch.

21. The three-dimensionally shaped thermally conductive molded body according to any one of claims 13 to 20, wherein the thickness of the bottom part outer layer is 0.5 mm or less, and the thickness of the three-dimensionally shaped thermally conductive molded body is 4.0 mm or less.

22. A method of manufacturing a three-dimensionally shaped thermally conductive molded body according to any one of claims 13 to 21, comprising:

preparing a mixture containing a thermally conductive material and a silicone-based material;
preparing a mold that can form the protruding layers and gaps of the three-dimensionally shaped thermally conductive molded body;
providing an extensible film on the mold so as to enable contact with the mold inner surface;
overlaying the extensible film on the mold;
filling the aforementioned mixture into a hollow part of the mold on which the extensible film has been overlaid;
placing the laminate body for the bottom part outer layer having a bottom part outer layer on the release film onto the mold such that the bottom part outer layer covers the mixture filled in the hollow part and the release film forms the outermost layer;
curing the mixture and the silicone-based material of the bottom part outer layer; and
providing the three-dimensionally shaped thermally conductive molded body by removing the three-dimensionally shaped thermally conductive molded body with an extensible film from the mold, after optionally cooling the mold, and optionally removing the extensible film and/or the release film.

23. The method of manufacturing the three-dimensionally shaped thermally conductive molded body according to claim 11, 12, or 22, wherein the extensible film includes at least one resin selected from polyolefin resins, polymethylpentene resins, ionomer resins, and fluorine-based resins.

[FIG. 1]

(A)

[FIG. 2A]

(B)

[FIG. 2B]

(C)

[FIG. 2C]

(D)

[FIG. 2D]

(E)

[FIG. 2E]

(F)

[FIG. 2F]

(G)

[FIG. 2G]

(H)

[FIG. 2H]

[FIG. 3]

[FIG. 4]

[FIG. 5]

[FIG. 6]

[FIG. 7]

[FIG. 8]

[FIG. 9]

[FIG. 10]

EP 3 533 579 A1

[FIG. 11]

[FIG. 12]

[FIG. 13]

[FIG. 14]

# INTERNATIONAL SEARCH REPORT

| International application No |
| --- |
| PCT/IB2017/001308 |

**A. CLASSIFICATION OF SUBJECT MATTER**
INV. B29C39/00    B29C39/02    B29C39/10    H01L23/367    H01L23/373
H01L23/433
ADD. B29K83/00

According to International Patent Classification (IPC) or to both national classification and IPC

**B. FIELDS SEARCHED**

Minimum documentation searched (classification system followed by classification symbols)
B29C  B29K  H01L

Documentation searched other than minimum documentation to the extent that such documents are included in the fields searched

Electronic data base consulted during the international search (name of data base and, where practicable, search terms used)
EPO-Internal

**C. DOCUMENTS CONSIDERED TO BE RELEVANT**

| Category* | Citation of document, with indication, where appropriate, of the relevant passages | Relevant to claim No. |
| --- | --- | --- |
| X | US 2008/290504 A1 (KARAVAKIS KONSTANTINE N [US] ET AL) 27 November 2008 (2008-11-27) paragraphs [0002], [0008], [0009], [0022], [0030] - [0032], [0035], [0037], [0041] figures 1A-7B | 1-23 |
|   | ----- |   |
| X | US 2004/118579 A1 (MCCUTCHEON JEFFREY W [US] ET AL) 24 June 2004 (2004-06-24) paragraphs [0001], [0004], [0009], [0038], [0042] - [0045], [0050], [0066], [0068] figures 1A-1C | 1-10, 13-21 |
| A |   | 11,12, 22,23 |
|   | ----- |   |
|   | -/-- |   |

| X | Further documents are listed in the continuation of Box C. | | X | See patent family annex. |
| --- | --- | --- | --- | --- |

* Special categories of cited documents :

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
| --- | --- |
| 14 March 2018 | 23/03/2018 |

| Name and mailing address of the ISA/ European Patent Office, P.B. 5818 Patentlaan 2 NL - 2280 HV Rijswijk Tel. (+31-70) 340-2040, Fax: (+31-70) 340-3016 | Authorized officer Dias, Filipe |
| --- | --- |

Form PCT/ISA/210 (second sheet) (April 2005)

## INTERNATIONAL SEARCH REPORT

| | International application No |
|---|---|
| | PCT/IB2017/001308 |

**C(Continuation). DOCUMENTS CONSIDERED TO BE RELEVANT**

| Category* | Citation of document, with indication, where appropriate, of the relevant passages | Relevant to claim No. |
|---|---|---|
| X | US 2015/303129 A1 (OUDERKIRK ANDREW J [US] ET AL) 22 October 2015 (2015-10-22) | 1-10, 13-21 |
| A | paragraphs [0002], [0021], [0026], [0028], [0032] - [0034] figures 2A-2B | 11,12, 22,23 |
| | ----- | |
| X | EP 0 297 793 A2 (AMERICAN TELEPHONE & TELEGRAPH [US]) 4 January 1989 (1989-01-04) | 1-10, 13-21 |
| A | page 2, line 8 - line 9 page 3, line 14 - line 34 figure 2 | 11,12, 22,23 |
| | ----- | |

Form PCT/ISA/210 (continuation of second sheet) (April 2005)

## INTERNATIONAL SEARCH REPORT
Information on patent family members

| International application No |
|---|
| PCT/IB2017/001308 |

| Patent document cited in search report | | | Publication date | Patent family member(s) | | | Publication date |
|---|---|---|---|---|---|---|---|
| US 2008290504 | A1 | 27-11-2008 | NONE | | | | |
| US 2004118579 | A1 | 24-06-2004 | AU | 2003290919 | A1 | 29-07-2004 |
| | | | | CN | 1748011 | A | 15-03-2006 |
| | | | | EP | 1572824 | A1 | 14-09-2005 |
| | | | | JP | 4343848 | B2 | 14-10-2009 |
| | | | | JP | 2006513390 | A | 20-04-2006 |
| | | | | KR | 20050084401 | A | 26-08-2005 |
| | | | | TW | I333822 | B | 21-11-2010 |
| | | | | US | 2004118579 | A1 | 24-06-2004 |
| | | | | US | 2005077618 | A1 | 14-04-2005 |
| | | | | US | 2008282542 | A1 | 20-11-2008 |
| | | | | WO | 2004061035 | A1 | 22-07-2004 |
| US 2015303129 | A1 | 22-10-2015 | CN | 104768742 | A | 08-07-2015 |
| | | | | KR | 20150085518 | A | 23-07-2015 |
| | | | | TW | 201422799 | A | 16-06-2014 |
| | | | | US | 2015303129 | A1 | 22-10-2015 |
| | | | | WO | 2014074538 | A1 | 15-05-2014 |
| EP 0297793 | A2 | 04-01-1989 | CA | 1286793 | C | 23-07-1991 |
| | | | | DE | 3874244 | D1 | 08-10-1992 |
| | | | | DE | 3874244 | T2 | 24-12-1992 |
| | | | | EP | 0297793 | A2 | 04-01-1989 |
| | | | | ES | 2034234 | T3 | 01-04-1993 |
| | | | | JP | H0671054 | B2 | 07-09-1994 |
| | | | | JP | S6459840 | A | 07-03-1989 |
| | | | | US | 4838347 | A | 13-06-1989 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3492656 B
- JP 2728607 B

- JP 2938340 B
- JP 3382842 B